# EUROPEAN PATENT SPECIFICATION

(11) **EP 2 293 342 B1**
(45) Date of publication and mention of the grant of the patent: **27.11.2013**
(21) Application number: 09758354.6
(22) Date of filing: 03.06.2009
(51) Int. Cl.: H01L 31/04, C23C 16/50, H01L 21/205, C23C 16/44, C23C 16/458, C23C 16/509, C23C 16/54

(54) **THIN-FILM SOLAR CELL MANUFACTURING APPARATUS**
VORRICHTUNG ZUR HERSTELLUNG EINER DÜNNFILMSOLARZELLE
APPAREIL DE FABRICATION D UNE CELLULE SOLAIRE À COUCHE MINCE

(30) Priority: 06.06.2008 JP 2008149936
(43) Date of publication of application: 09.03.2011
(73) Proprietor: Ulvac, Inc., Chigasaki-shi Kanagawa 253-8543 (JP)
(72) Inventor: SHIMIZU Yasuo, Chigasaki-shi Kanagawa 253-8543 (JP); OGATA Hideyuki, Chigasaki-shi Kanagawa 253-8543 (JP); MATSUMOTO Koichi, Chigasaki-shi Kanagawa 253-8543 (JP); NOGUCHI Takafumi, Chigasaki-shi Kanagawa 253-8543 (JP); WAKAMORI Jouji, Chigasaki-shi Kanagawa 253-8543 (JP); OKAYAMA Satohiro, Chigasaki-shi Kanagawa 253-8543 (JP); MORIOKA Yawara, Chigasaki-shi Kanagawa 253-8543 (JP); SUGIYAMA Noriyasu, Chigasaki-shi Kanagawa 253-8543 (JP); SHIGETA Takashi, Chigasaki-shi Kanagawa 253-8543 (JP); KURIHARA Hiroyuki, Chigasaki-shi Kanagawa 253-8543 (JP)
(74) Representative: Eisenführ, Speiser & Partner
(86) International application number: PCT/JP2009/060168
(87) International publication number: WO 2009/148087

(56) References cited:
- JP-A- 11 330 520
- JP-A- 2002 359 203
- JP-A- 2003 324 075
- JP-A- 2004 335 601
- JP-A- 2005 158 982
- JP-A- 2008 034 469
- JP-U- 1 174 922

## Description

### BACKGROUND OF THE INVENTION

### Field of the Invention

The present invention relates to a thin-film solar cell manufacturing apparatus.

### Description of Related Art

Although most current solar cells are of a single crystal Si type and a polycrystal Si type, there are growing concerns about material shortages or the like of Si. Thus, the demand has recently been increasing for thin-film solar cells formed with a thin-film Si-layer in which the manufacturing cost is low and the risk of material shortages is low. Moreover, in addition to conventional thin-film solar cell having only an a-Si (amorphous silicon) layer, the demand for tandem-type thin-film solar cells aiming at improvements in conversion efficiency has recently been increasing by laminating an a-Si-layer and a µc-Si (microcrystalline silicon) layer.
A plasma-CVD apparatus is often used for film forming of a thin-film Si-layer (semiconductor layer) of the thin-film solar cells. As this type of plasma-CVD apparatus, a single-wafer-type PE-CVD (plasma CVD) apparatus, an in-line type PE-CVD apparatus, a batch-type PE-CVD apparatus, and the like exist.

When the conversion efficiency as a thin-film solar cell is taken into consideration, the µc-Si-layer of the above tandem-type solar cell needs to be formed as a film with a film thickness (approximately 1.5 µm) of approximately five times larger than the a-Si-layer. Additionally, since the µc-Si-layer needs to uniformly form a good microcrystal film, there is also a limit to increasing the film formation rate. Thus, in order to compensate for this, productivity is required to improve by virtue of an increase in the number of batches or the like. That is, an apparatus which can realize higher throughput at a low film formation rate is needed.

Additionally, a CVD apparatus aiming at forming a high-quality thin film and lowering manufacturing and maintenance costs is also proposed. For example, the CVD apparatus described in the following Japanese Unexamined Patent Application, First Publication No. 2005-139524 includes a substrate (base material) delivery/dispensing device, a film forming chamber group capable of storing a plurality of substrates, a transfer chamber, and a chamber transfer device. Moreover, an inlet port of the film forming chamber is provided with an airtight shutter, and an inlet port of a storage chamber in the transfer chamber is always opened.

In order to form a film on a substrate with the CVD apparatus, the transfer chamber is transferred to the position of the substrate delivery/dispensing device by a chamber transfer device, and a substrate carrier is transferred toward the transfer chamber. Additionally, the transfer chamber is joined to the film forming chamber by the chamber transfer device, the substrate carrier is transferred to the film forming chamber, and a film is formed on the substrate. The film forming chamber is provided with a plurality of heaters for heating the substrate, and a plurality of electrodes for making the film forming gas supplied to the film forming chamber into plasma. The heaters and electrodes are lined up together so as to alternate, respectively, and a substrate is arranged between each heater and each electrode.

### [Patent Citation 1]

Japanese Unexamined Patent Application, First Publication No. 2005-139524

Meanwhile, in the above-described CVD apparatus, a film may be formed even on a heater or electrode when a film is formed on a substrate. When a film is formed on these heaters or electrodes, appropriate film forming is not performed on the substrate, or production efficiency decreases. Thus, periodic maintenance work, such as replacing a heater or an electrode according to the frequency of use of the CVD apparatus is needed.

When such maintenance work is performed, the heaters and the electrodes are lined up within the film forming chamber so as alternate respectively. Thus the work space for performing maintenance work will be limited, and it is hard to perform maintenance work. For this reason, there is a problem in that the burden of maintenance work will increase.
Additionally, in performing maintenance work, first, it is necessary to wait for a drop in the temperature within the film forming chamber to a desired temperature, and it is then necessary to perform maintenance work. For this reason, there is also a problem in that substantial time is taken for maintenance work, the CVD apparatus should be stopped during this time, and the production efficiency (operating rate) will decrease.

### SUMMARY OF THE INVENTION

The present invention has been made in consideration of the above circumstances, and the object thereof is to provide a thin-film solar cell manufacturing apparatus capable of reducing the burden of the maintenance work, and preventing a decrease in production efficiency even if the maintenance work is performed.

The present invention has adopted the following measures in order to solve the above problems and achieve the relevant object. That is:
(1) A thin-film solar cell manufacturing apparatus of the present invention includes a film forming chamber which stores a substrate; and an electrode unit which performs film formation using a CVD method on the substrate in the film forming chamber. The electrode unit has an anode and a cathode; and a side plate portion which holds the anode and the cathode and forms a part of a wall portion of the film forming chamber, and is attachable to and detachable from the film forming chamber.
(2) In the thin-film solar cell manufacturing apparatus described in the above (1), a configuration may be adopted which includes the cathode and a pair of the anodes, and in which the respective anodes are arranged so as to face the cathode at a predetermined distance from the cathode.

According to invention described in the above (1) and (2), the electrode unit having the cathode and the anodes can be easily separated from the film forming chamber by separating from the film forming chamber at the side plate portion. For this reason, the electrode unit can be removed and subjected to maintenance as a single body, and it is possible to secure a large working space around the electrode unit. Hence, it is possible to reduce the burden of the maintenance work.
Additionally, in the electrode unit as a single body separated from the film forming chamber, for example, it is possible to adjust the separation distance between the cathode and the anodes, or to connect a dummy load to the cathode and the anodes, thereby adjusting the impedances of the cathode and the anodes. For this reason, various adjustments required to operate the thin-film solar cell manufacturing apparatus can be performed off-line.

(3) In the thin-film solar cell manufacturing apparatus described in the above (1), the electrode unit may further include an opening and closing unit for changing the opening angle of the anode with respect to the cathode.
In this case, the opening angle of the anode can be changed by the opening and closing unit, and the respective facing surfaces of the anode and the cathode can be brought into an exposed state. That is, the respective facing surfaces of the anode and the cathode on which a film is often formed except the substrate can be exposed. For this reason, it becomes easy to perform maintenance work on the anode and cathode, and the burden of the maintenance work can be further reduced.

(4) In the above case (3), the opening and closing unit may be provided at the anode on the side of the side plate portion.
In this case, the respective facing surfaces of the anode and the cathode can be brought into an exposed state by opening the anode by the opening and closing unit. That is, the respective facing surfaces of the anode and the cathode on which a film is often formed except the substrate can be exposed. Hence, it is possible to further reduce the burden of the maintenance work on the thin-film solar cell manufacturing apparatus. Moreover, since the portion between the anode and the cathode can be opened and closed while the anode and the cathode are attached to the side plate portion, maintenance becomes possible without removing the anode and the cathode from the side plate portion.

(5) The thin-film solar cell manufacturing apparatus described in the above (1) may further include an auxiliary unit having the same configuration as the electrode unit.
In this case, for example, even if the electrode unit is separated from the film forming chamber in order to perform maintenance work on the electrode unit, the auxiliary unit can be mounted to the film forming chamber, instead of the electrode unit. In this case, the thin-film solar cell manufacturing apparatus can be normally operated using the auxiliary unit until the maintenance work on the electrode unit is ended. Moreover, since the auxiliary unit has the same configuration as the electrode unit, appropriate film forming can be performed on the substrate even if the auxiliary unit is mounted to the film forming chamber. For this reason, even if the maintenance work is performed, a decrease in production efficiency can be prevented.

(6) In the thin-film solar cell manufacturing apparatus described in the above (1), a configuration may be adopted in which a temperature control unit for adjusting the heating temperature of the substrate is built into the anode, and the temperature control unit and the anode constitutes an anode unit.
In this case, it is possible to efficiently control the temperature of the substrate. Additionally, since it becomes unnecessary to provide a temperature control unit separately from the anode, the thin-film solar cell manufacturing apparatus can be miniaturized.

(7) In the thin-film solar cell manufacturing apparatus described in the above (1), a configuration may be adopted in which the cathode and the anode are attached so as to be substantially perpendicular to the side plate portion in plan view, a wall portion of the film forming chamber is provided with an opening, and the electrode unit is attached to the film forming chamber when the cathode and the anode are inserted into the film forming chamber through the opening and the side plate portion closes the opening.
(8) In the thin-film solar cell manufacturing apparatus described in the above (1), a configuration may be adopted in which the cathode and the anode are attached so as to be substantially perpendicular to the side plate portion in plan view, a wall portion of the film forming chamber is provided with an opening which is closed by the side plate portion, and the cathode and the anode are detached to the outside of the film forming chamber through the opening by removing the side plate portion closing the opening.
According to inventions described in the above (7) and (8), it is possible to more easily perform the maintenance work on the electrode unit.

(9) In the thin-film solar cell manufacturing apparatus described in the above (1), the electrode unit may further include a driving unit which allows the anode to approach to and separate from the cathode.
In this case, since the anode moves in the directions in which the anode approaches and separates from the cathode unit, the gap between the anode and the cathode unit can be increased when a substrate enters and exits the film forming chamber. On the other hand, when a film is formed on the surface to be film-formed of the substrate, the gap between the anode and the cathode unit can be decreased. For this reason, it is possible to facilitate entrance and exit of the substrate from the film forming chamber while improving the quality of a film to be formed, and it is possible to improve productivity.

(10) In the thin-film solar cell manufacturing apparatus described in the above (1), a configuration may be adopted in which the cathode is a shower plate which supplies film forming gas to a surface to be film-formed of the substrate, and the side plate portion has an introducing portion into which the film forming gas is introduced.
In this case, it becomes unnecessary to separately provide the cathode and the shower plate, and it is possible to achieve simplification and low cost of the thin-film solar cell manufacturing apparatus. Additionally, uniform introduction of the film forming gas into the film formation space and uniform generation of plasma become possible.

(11) In the thin-film solar cell manufacturing apparatus described in the above (1), the electrode unit may further include a mask unit which limits the film formation range at the outer-edge portion of the substrate.
In this case, formation of a film on an unnecessary portion on the surface to be film-formed of a substrate, that is, the outer-edge portion of the substrate, can be prevented. Moreover, since the mask unit can be separated from the film forming chamber integrally with the electrode unit, cleaning of the mask unit becomes easy.

(12) In the thin-film solar cell manufacturing apparatus described in the above (1), the electrode unit may further include a truck.
In this case, it is possible to easily transfer the electrode unit by the truck, and maintenance work efficiency can be further improved.

(13) In the above case (12), the truck may be capable of being connected to and separated from the side plate portion.
In this case, the truck can be separated from the electrode unit after the electrode unit is connected to the film forming chamber, and can be used for the transfer of other electrode units as a common truck. For this reason, it is possible to share the truck between a plurality of electrode units, and the manufacturing cost of the thin-film solar cell manufacturing apparatus can be further reduced.

According to the present invention, the electrode unit having the cathode and the anodes can be easily separated from the film forming chamber. For this reason, maintenance work can be performed on the electrode unit as a single body, and it is possible to secure a large working space. Hence, it is possible to reduce the burden of the maintenance work. Additionally, even if the electrode unit is separated from the film forming chamber in order to perform maintenance work, the auxiliary unit can be mounted to the film forming chamber, instead of the electrode unit. In this case, the thin-film solar cell manufacturing apparatus can be normally operated until the maintenance work on the electrode unit is ended. Moreover, since the auxiliary unit has the same configuration as the electrode unit, appropriate film forming can be performed on the substrate. For this reason, even if the maintenance work is performed, a decrease in production efficiency can be prevented.

### BRIEF DESCRIPTION OF THE DRAWINGS

FIG. 1 is a schematic sectional view of a thin-film solar cell related to an embodiment of the present invention.
FIG. 2 is a schematic plan view of a thin-film solar cell manufacturing apparatus related to the embodiment.
FIG. 3A is a perspective view of a film forming chamber of the embodiment.
FIG. 3B is a perspective view when the film forming chamber is seen from a different angle.
FIG. 3C is a side view of the film forming chamber.
FIG 4A is a perspective view of an electrode unit of the embodiment.
FIG. 4B is a perspective view when the electrode unit is seen from a different angle.
FIG. 4C is a view showing a modification of the electrode unit, and is an exploded perspective view of a part of the electrode unit.
FIG. 4D is a partial sectional view of a cathode unit and anode unit of the electrode unit of the embodiment.
FIG. 5A is a perspective view of a loading-ejecting chamber of the embodiment.
FIG. 5B is a perspective view when the loading-ejecting chamber is seen from a different angle.
FIG. 6 is a perspective view showing a schematic configuration of a push-pull mechanism of the embodiment.
FIG. 7A is a perspective view showing a schematic configuration of a substrate replacement chamber of the embodiment.
FIG. 7B is a front view of the substrate replacement chamber.
FIG. 8 is a perspective view of a substrate storage holder of the embodiment.
FIG. 9 is a perspective view of a carrier of the embodiment.
FIG. 10 is an explanatory view (1) showing a process of a method for manufacturing a thin-film solar cell of the embodiment.
FIG 11 is an explanatory view (2) showing the subsequent process of the method for manufacturing a thin-film solar cell.
FIG. 12 is an explanatory view (3) showing the subsequent process of the method for manufacturing a thin-film solar cell.
FIG 13 is an explanatory view (4) showing the subsequent process of the method for manufacturing a thin-film solar cell.
FIG 14 is an explanatory view (5) showing the subsequent process of the method for manufacturing a thin-film solar cell.
FIG 15A is an explanatory view showing the operation of the push-pull mechanism of the embodiment.
FIG 15B is an explanatory view showing the operation of the push-pull mechanism of the embodiment.
FIG 16 is an explanatory view (6) showing the subsequent process of the method for manufacturing a thin-film solar cell of the embodiment.
FIG 17 is an explanatory view (7) showing the subsequent process of the method for manufacturing a thin-film solar cell.
FIG 18 is an explanatory view (8) showing the subsequent process of the method for manufacturing a thin-film solar cell, and is a schematic sectional view when a substrate is inserted into the electrode unit.
FIG. 19 is an explanatory view (9) showing the subsequent process of the method for manufacturing a thin-film solar cell.
FIG 20 is an explanatory view (10) showing the subsequent process of the method for manufacturing a thin-film solar cell.
FIG 21 is an explanatory view (11) showing the subsequent process of the method for manufacturing a thin-film solar cell, and is a partial sectional view when a substrate is set on the electrode unit.
FIG 22 is an explanatory view (12) showing the subsequent process of the method for manufacturing a thin-film solar cell.
FIG 23 is an explanatory view (13) showing the subsequent process of the method for manufacturing a thin-film solar cell.
FIG 24 is an explanatory view (14) showing the subsequent process of the method for manufacturing a thin-film solar cell.
FIG 25 is an explanatory view (15) showing the subsequent process of the method for manufacturing a thin-film solar cell.
FIG 26 is a perspective view for explaining a maintenance procedure of the electrode unit of the embodiment.

### DETAILED DESCRIPTION OF THE INVENTION

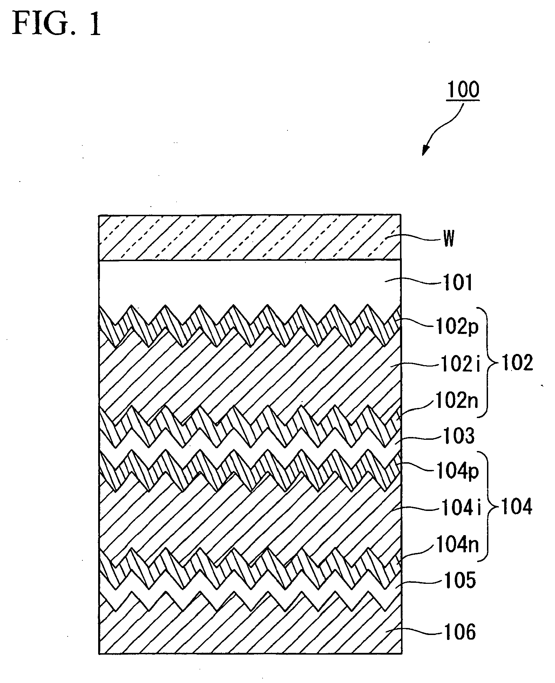

A thin-film solar cell manufacturing apparatus related to an embodiment of the present invention will be described with reference to FIGS. 1 to 26.

### (Thin-film Solar Cell)

FIG. 1 is a schematic sectional view of a thin-film solar cell 100 of the embodiment. As shown in FIG. 1, the thin-film solar cell 100 is configured such that a glass substrate W which constitutes the surface of the solar cell; a top electrode 101 made of a transparent-electroconductive film provided on the glass substrate W; a top cell 102 made of amorphous silicon; an intermediate electrode 103 made of a transparent-electroconductive film provided between the top cell 102 and a bottom cell 104 which will be described later; the bottom cell 104 made of microcrystalline silicon; a buffer layer 105 made of a transparent-electroconductive film; and a back electrode 106 made of a metal film are laminated. That is, the thin-film solar cell 100 is an a-Si/microcystal Si tandem-type solar cell. In the thin-film solar cell 100 of such tandem structure, power generation efficiency can be improved by absorbing short-wavelength light by the top cell 102 and absorbing long-wavelength light by the bottom cell 104.

A three-layer structure of a p-layer (102p), i-layer (102i), and n-layer (102n) of the top cell 102 is formed from amorphous silicon. Additionally, a three-layer structure of a p-layer (104p), i-layer (104i), and n-layer (104n) of the bottom cell 104 is made of microcrystalline silicon.

In the thin-film solar cell 100 having such a configuration, when an energy particle called a photon in sunlight strikes the i-layer, an electron and a positive hole (hole) are generated by a photovoltaic effect, the electron moves toward the n-layer and the positive hole moves toward the p-layer. Light energy can be converted into electrical energy by taking out the electron/positive hole generated by the photovoltaic effect using the top electrode 101 and the back electrode 106.

Additionally, the intermediate electrode 103 is provided between the top cell 102 and the bottom cell 104, whereby a part of the light which passes through the top cell 102 and reaches the bottom cell 104 is reflected by the intermediate electrode 103 and enters the top cell 102 again. Therefore, the sensitivity characteristics of the cell improve, and the power generation efficiency improves.

Additionally, the sunlight which has entered from the glass substrate W side passes through the respective layers, and is then reflected by the back electrode 106. In order to improve the conversion efficiency of light energy, the thin-film solar cell 100 adopts a texture structure aiming at a prismatic effect which extends the optical path of the sunlight which has entered the top electrode 101, and the confinement effect of light.

### (Thin-film Solar Cell Manufacturing Apparatus)

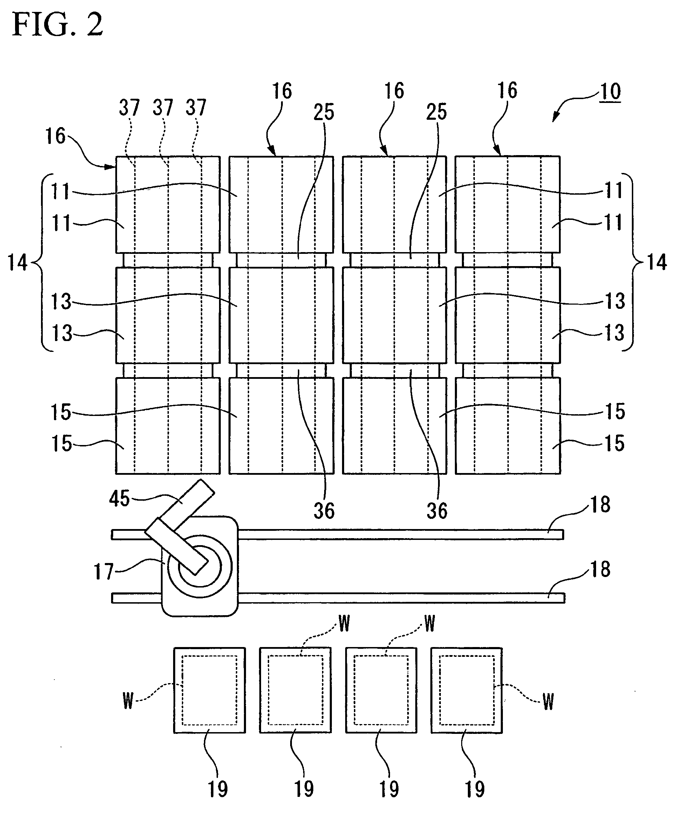

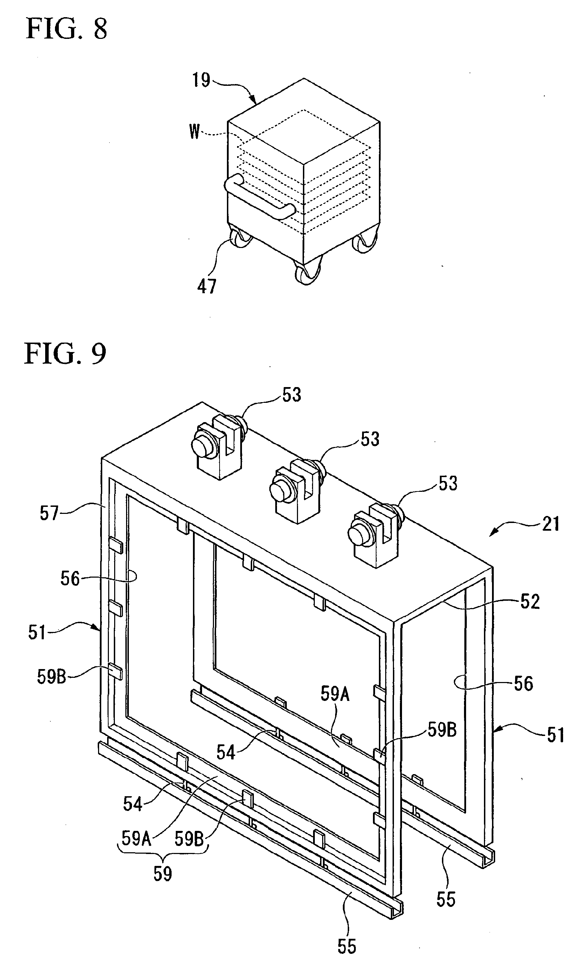

FIG. 2 is a schematic plan view of the thin-film solar cell manufacturing apparatus related to the embodiment. As shown in FIG. 2, the thin-film solar cell manufacturing apparatus 10 includes film forming chambers 11 capable of simultaneously film-forming bottom cells 104 (semiconductor layers) made of microcrystalline silicon on a plurality of glass substrates W; loading-ejecting chambers 13 capable of simultaneously storing pre-film-formation-processed substrates W1 (glass substrates W) to be transported to the film forming chamber 11 and post-film-formation-processed substrates W2 (glass substrates W) which have been transported from the film forming chamber 11; a substrate replacement chamber 15 where the pre-film-formation-processed substrates W1 and the post-film-formation-processed substrates W2 are attached to and detached from a carrier 21 (refer to FIG. 9); a substrate replacement robot 17 for attaching and detaching the glass substrates W to/from the carrier 21, and substrate storage holders 19 which store the glass substrates W in order to convey the glass substrates W to separate processing chambers. In addition, in the embodiment, four substrate film formation lines 16 each including the film forming chamber 11, the loading-ejecting chamber 13, and the substrate replacement chamber 15 are provided. The substrate replacement robot 17 is adapted to be able to move on rails 18 laid on a floor surface so that transfer of the glass substrates W to all the substrate film formation lines 16 can be performed by one substrate replacement robot 17. Moreover, the film forming chamber 11 and the loading-ejecting chamber 13 are integrated together to constitute a substrate film formation module 14, and have sizes such that the module can be loaded into an autotruck.

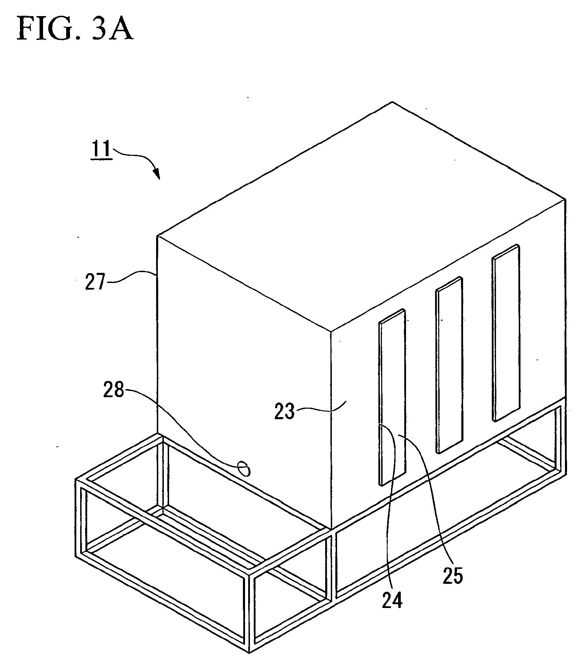

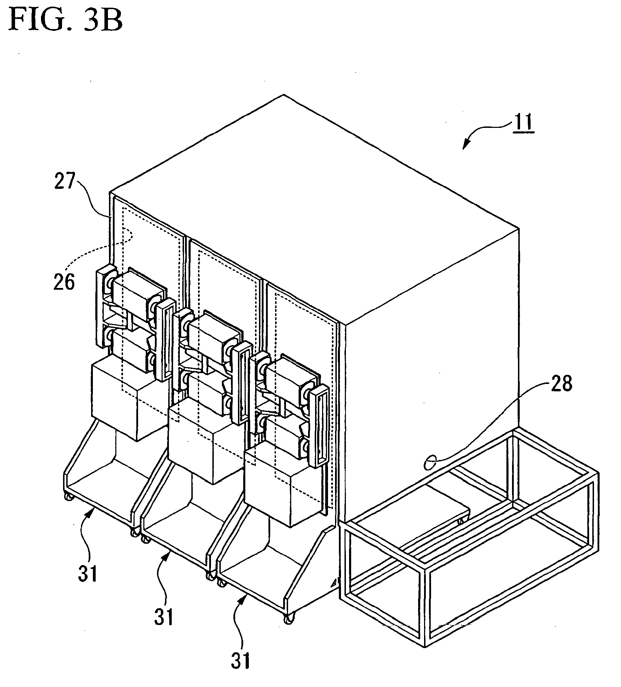

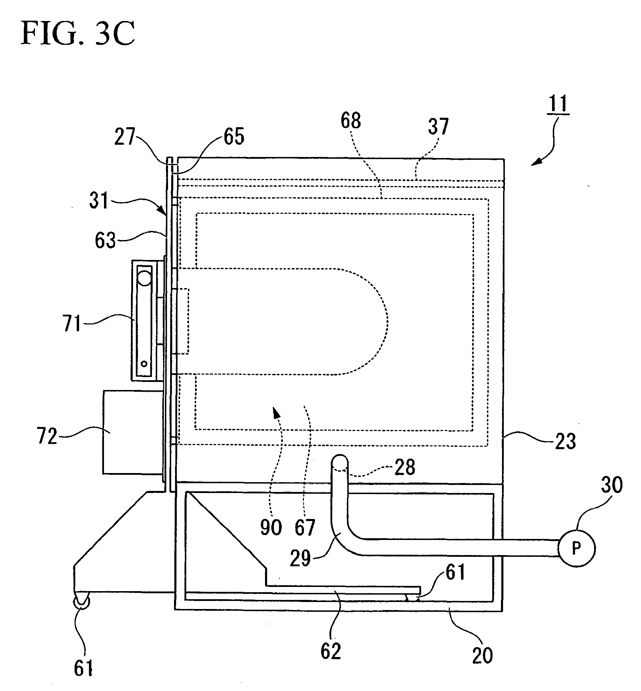

FIGS. 3A to 3C are schematic configuration views of the film forming chamber 11. FIG. 3A is a perspective view, FIG. 3B is a perspective view as seen from an angle different from FIG. 3A, and FIG 3C is a side view.
As shown in these FIGS. 3A to 3C, the film forming chamber 11 is formed in the shape of a box. A lateral surface 23 of the film forming chamber 11 connected to the loading-ejecting chamber 13 is formed with three carrier transfer inlet ports 24 which allow the carrier 21 on which the glass substrates W are mounted to pass therethrough. The carrier transfer inlet ports 24 are respectively provided with shutters 25 which open and close the carrier transfer inlet ports 24. When a shutter 25 is closed, the carrier transfer inlet port 24 is sealed securing airtightness. Three electrode units 31 for forming films on the glass substrates W are attached to a lateral surface 27 opposite to the lateral surface 23. The electrode units 31 are attachable to and detachable from the film forming chamber 11. A vacuuming pipe 29 for vacuuming the space within the film forming chamber 11 is connected to an opening 28 at a lateral lower portion of the film forming chamber 11 (refer to FIG. 3C; the illustration is omitted in FIGS. 3A and 3B). The vacuuming pipe 29 is provided with a vacuum pump 30.

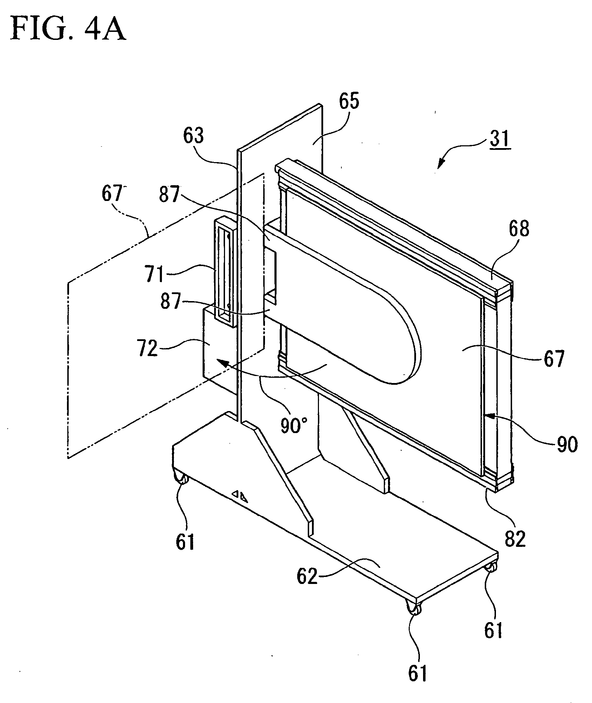

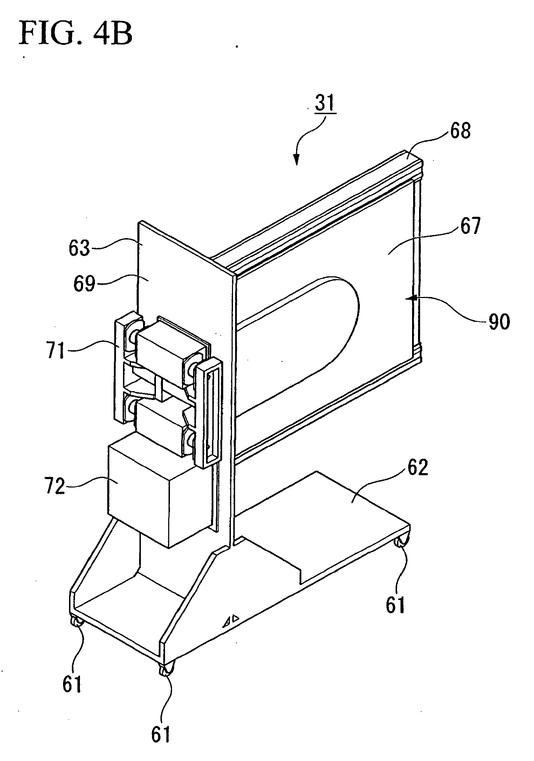

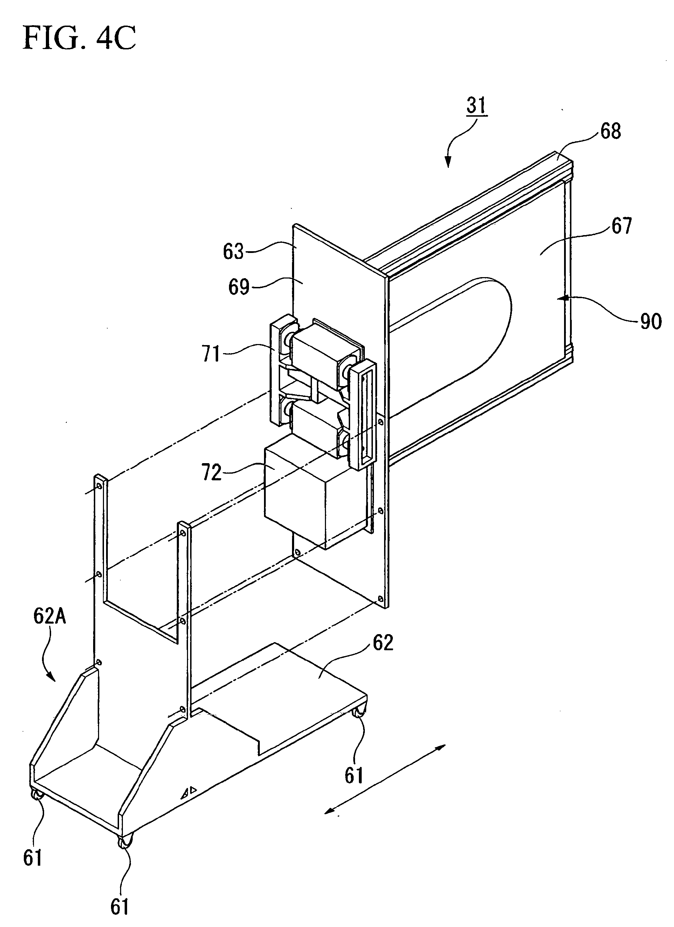

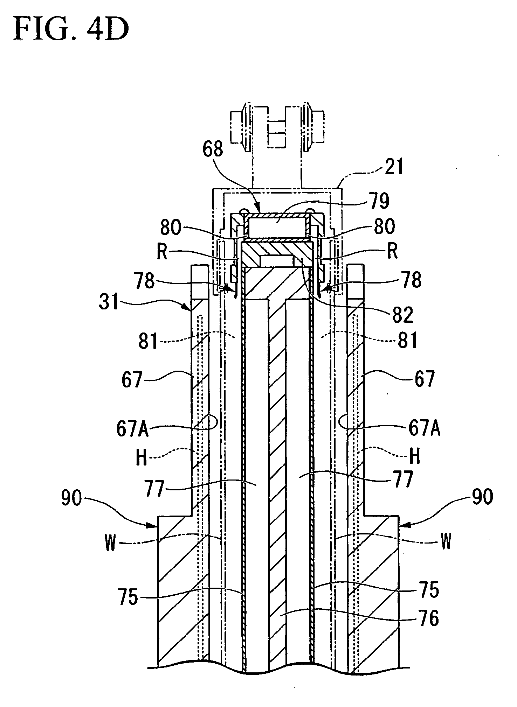

FIGS. 4A to 4D are schematic configuration views of the electrode unit 31. FIG 4A is a perspective view, FIG. 4B is a perspective view as seen from an angle different from FIG. 4A, FIG. 4C is a perspective view showing a modification of the electrode unit 31, and FIG. 4D is a partial sectional view of a cathode unit and an anode (counter electrode).
The electrode units 31 are attachable to and detachable from three openings 26 formed in the lateral surface 27 of the film forming chamber 11 (refer to FIG. 3B). Wheels 61 are provided at each of the four corners of the lower portion, and the electrode units 31 are movable on the floor surface. On a bottom plate portion 62 to which the wheels 61 are attached, a side plate portion 63 is erected along the vertical direction. The side plate portion 63 has a size such that the side plate portion can block the opening 26 of the lateral surface 27 of the film forming chamber 11.
As shown in the modification of FIG 4C, the bottom plate portion 62 with the wheels 61 may be a truck 62A which can be separated from and connected to the electrode unit 31. In this case, the truck 62A can be separated from the electrode unit 31 after the electrode unit 31 is connected to the film forming chamber 11, and can be used for the transfer of other electrode units 31 as a common truck 62A.

The side plate portion 63 forms a part of a wall surface of the film forming chamber 11. One surface (surface which faces the inside of the film forming chamber 11) 65 of the side plate portion 63 is provided with anodes 67 and a cathode unit 68 which are arranged on both surfaces of the glass substrate W during the film formation processing. The electrode unit 31 of the embodiment includes a pair of anodes 67 arranged so as to be separated from each other with the cathode unit 68 therebetween. Films can be simultaneously formed on two glass substrates W by one electrode unit 31. Respective glass substrates W during film formation processing are arranged on both sides of the cathode unit 68, respectively, so as to face each other substantially parallel to the vertical direction. Two anodes 67 are arranged outside respective glass substrates W in the thickness direction in a state where the anodes face the glass substrates W, respectively.

A drive mechanism 71 for driving the anodes 67, and a matching box 72 for feeding electric power to the cathode unit 68 when a film is formed are attached to the other surface 69 of the side plate portion 63. Moreover, the side plate portion 63 is formed with a connecting portion for piping (not shown) which supplies film forming gas to the cathode unit 68.

A heater H is built in each anode 67 as a temperature control unit for adjusting the temperature of the glass substrate W Additionally, the two anodes 67 and 67 are movable in directions (horizontal directions) in which the anodes approach to and separate from each other by the drive mechanism 71 provided at the side plate portion 63, and the separation distance between each glass substrate W and the cathode unit 68 is controllable. Specifically, before films are formed on the glass substrates W, the two anodes 67 and 67 move toward the cathode unit 68, contact the glass substrate W, and move in directions in which the anodes approach the cathode unit 68, thereby adjusting the separation distance between the glass substrates W and the cathode unit 68 to a desired distance. Thereafter, films are formed, and the anodes 67 and 67 move in directions in which the anodes separate from each other after the end of film forming. Thereafter, the glass substrates W can be easily taken out of the electrode unit 31.

Moreover, each anode 67 is attached to the drive mechanism 71 via a hinge portion 87, and can be turned so as to be opened and closed until the surface 67A of the anode 67 which faces the cathode unit 68 becomes substantially parallel to one surface 65 of the side plate portion 63, in a state which the electrode unit 31 is pulled out of the film forming chamber 11. The hinge portion 87 is provided at the anode 67 on the side of the side plate portion 63. The hinge portion 87 is an opening and closing unit which enables respective facing surfaces (the details thereof will be described later) of the anode 67 and the cathode unit 68 to be simultaneously exposed. The anode 67 is adapted to be openable and closable with respect to the cathode unit 68 about the hinge portion 87. In addition, the opening/closing angle of the anode 67 is set to approximately 90° in plan view (refer to FIG 4A).

The cathode unit 68 has a shower plate 75 (=cathode), a cathode intermediate member 76, a discharge duct 79, and a floating capacitance member 82.
A pair of shower plates 75 formed with a plurality of small holes (not shown) is arranged on the surfaces of the cathode unit 68 which face the anodes 67, respectively so that the film forming gas can be jetted toward the glass substrates W. Moreover, the shower plates 75 and 75 form cathodes (high-frequency electrode) connected to the matching box 72. The cathode intermediate member 76 connected to the matching box 72 is provided between the two shower plates 75 and 75. That is, the shower plates 75 are arranged on both sides of the cathode intermediate member 76 in a state where the shower plates 75 are electrically connected to the cathode intermediate member 76.

The cathode intermediate member 76 and the shower plates (cathodes) 75 are formed from electrical conductors, and high frequency is applied to the shower plates (cathodes) 75 via the cathode intermediate member 76. For this reason, voltages of the same potential and phase for generating plasma are applied to the two shower plates 75 and 75.
The cathode intermediate member 76 is connected to the matching box 72 by a wiring line which is not shown. A space portion 77 is formed between the cathode intermediate member 76 and each shower plate 75. The film forming gas is introduced into the space portion 77 from a gas supply device (not shown). A pair of space portions 77 is separated from each other by the cathode intermediate member 76 interposed therebetween, and is individually formed so as to correspond to the shower plates 75 and 75, respectively. The gases discharged from the respective shower plates 75 and 75 are independently controlled. That is, the space portion 77 has a role as a gas supply passage. In the embodiment, the respective space portions 77 are separately formed so as to correspond to the shower plates 75 and 75, respectively. Thus, the cathode unit 68 has two gas supply passages.

A hollow discharge duct 79 is provided at a peripheral edge portion of the cathode unit 68 over its whole periphery. The discharge duct 79 is formed with a vacuuming port 80 for evacuating the film forming gas or reactive by-products (powder) within a film formation space 81. Specifically, the vacuuming port 80 is formed so as to face the film formation space 81 formed between the glass substrate W and the shower plate 75 when a film is formed. A plurality of vacuuming ports 80 is formed along the peripheral edge portion of the cathode unit 68, and is configured so that evacuation can be made substantially equal over its whole periphery. Additionally, the surface of the discharge duct 79 which faces the inside of the film forming chamber 11 at the lower portion of the cathode unit 68 is formed with an opening (not shown) so that the evacuated film forming gas can be discharged into the film forming chamber 11. The gas discharged into the film forming chamber 11 is evacuated to the outside through the vacuuming pipe 29 provided at a lateral lower portion of the film forming chamber 11. Additionally, the floating capacitance member 82 which has a dielectric body and/or laminating space is provided between the discharge duct 79 and the cathode intermediate member 76. The discharge duct 79 is connected to the ground potential. The discharge duct 79 also functions as a shield frame for preventing abnormal electrical discharge from the cathode 75 and the cathode intermediate member 76.

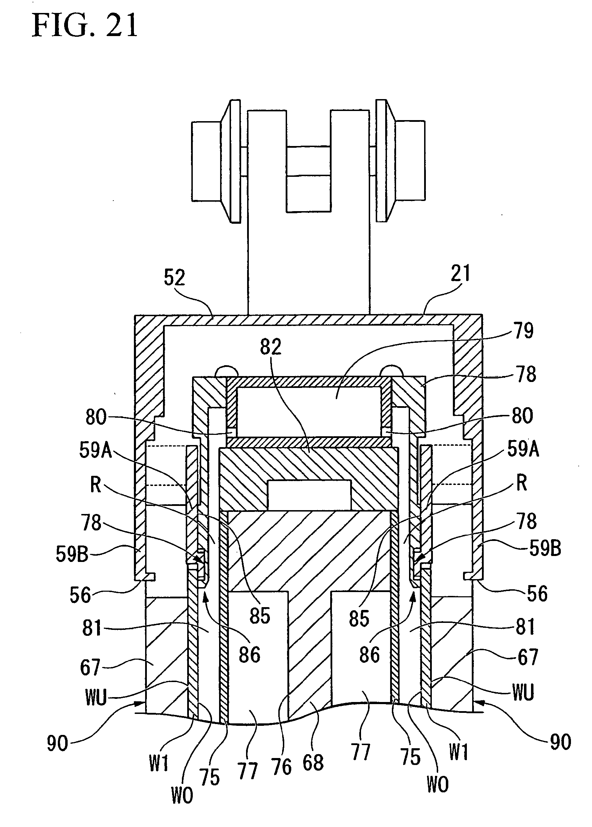

Moreover, a pair of masks 78 is provided at the peripheral edge portion of the cathode unit 68 so as to cover the part from the peripheral portion of the discharge duct 79 to the peripheral portion of the shower plate 75 (=cathode). Each of the masks 78 limits the film formation range of the outer-edge portion of the glass substrate W, covers a holding piece 59A (refer to FIGS. 9 and 21) of a holding portion 59 (which will be described later) provided at the carrier 21, and forms a gas flow passage R for guide the film forming gas or reactive by-products (powder) within the film formation space 81 to the discharge duct 79 integrated with the holding piece 59A when a film is formed. That is, the gas flow passage R is formed between the mask 78 which covers the carrier 21 (holding piece 59A) and the shower plate 75 and between the mask 78 and the discharge duct 79.

Returning to FIG. 2, a plurality of transfer rails 37 is laid between the film forming chamber 11 and the substrate replacement chamber 15 so that the carrier 21 can be transferred between the film forming chamber 11 and the loading-ejecting chamber 13 and between the loading-ejecting chamber 13 and the substrate replacement chamber 15. In addition, the transfer rails 37 are separated between the film forming chamber 11 and the loading-ejecting chamber 13, and the carrier transfer inlet ports 24 can be sealed by closing the shutters 25.

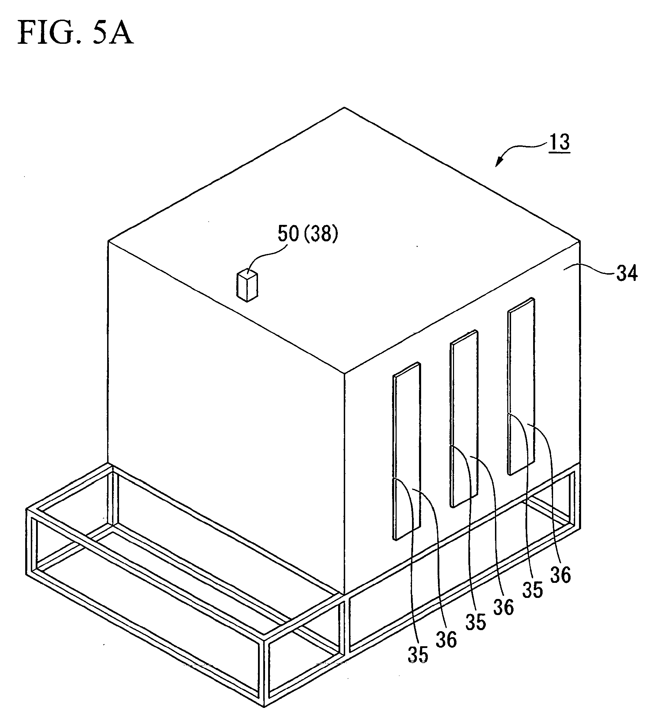

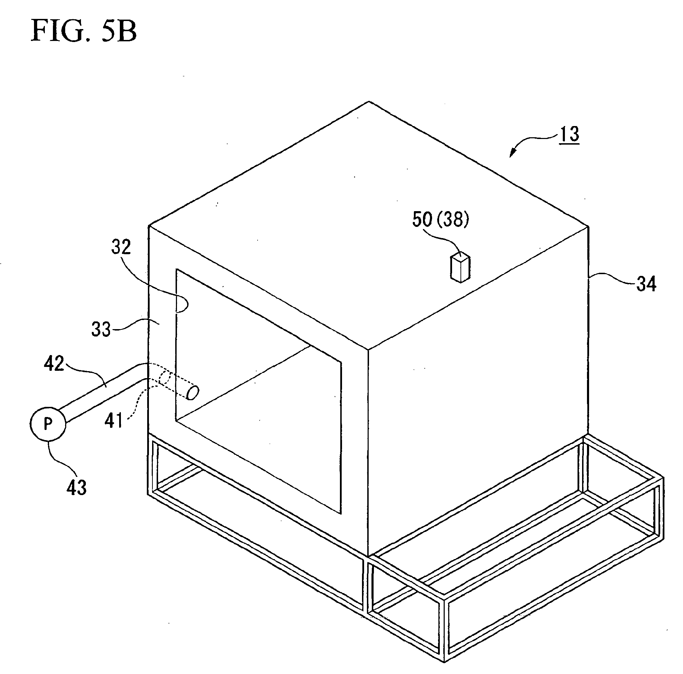

FIGS. 5A and 5B are schematic perspective views of the loading-ejecting chamber 13, and FIG 5A is a perspective view, and FIG 5B is a perspective view as seen from an angle different from FIG 5A. As shown in FIGS. 5A and 5B, the loading-ejecting chamber 13 is formed in the shape of a box. A lateral surface 33 is connected to the lateral surface 23 of the film forming chamber 11 while securing airtightness. The lateral surface 33 is formed with an opening 32 through which three carriers 21 can be inserted. A lateral surface 34 which is opposite to the lateral surface 33 is connected to the substrate replacement chamber 15. The lateral surface 34 is formed with three carrier transfer inlet ports 35 which allow the carrier 21 on which the glass substrates W are mounted to pass therethrough. Each carrier transfer inlet port 35 is provided with a shutter 36 which can secure airtightness. In addition, the respective transfer rails 37 are separated between the loading-ejecting chamber 13 and the substrate replacement chamber 15, and the carrier transfer inlet ports 35 can be sealed by closing the shutters 36.

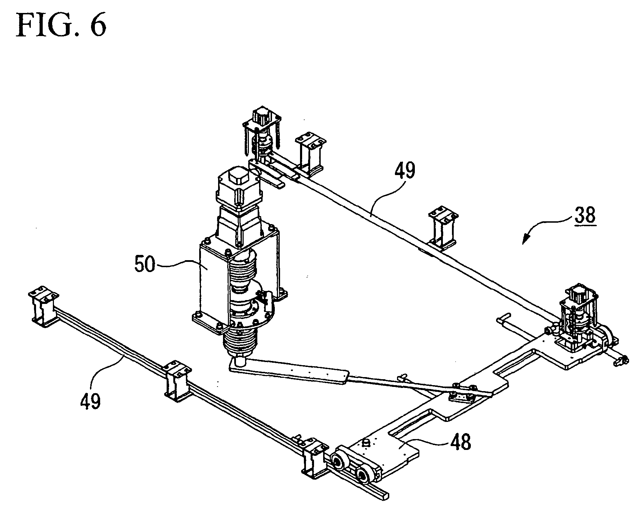

The loading-ejecting chamber 13 is provided with a push-pull mechanism 38 for transferring the carrier 21 between the film forming chamber 11 and the loading-ejecting chamber 13 along the transfer rails 37. As shown in FIG 6, the push-pull mechanism 38 includes a locking portion 48 for locking the carrier 21; a pair of guide members 49 provided at both ends of the locking portion 48, and disposed substantially parallel to the transfer rails 37; and a transfer device 50 for moving the locking portion 48 along both the guide members 49.

Moreover, a transfer mechanism (not shown) for transferring the carrier 21 by a predetermined distance toward a direction substantially orthogonal to the direction in which the transfer rails 37 are laid in plan view is provided within the loading-ejecting chamber 13 in order to simultaneously store the pre-film-formation-processed substrate W1 and the post-film-formation-processed substrate W2. A vacuuming pipe 42 for vacuuming the inside of the loading-ejecting chamber 13 is connected to a lateral lower portion 41 of the loading-ejecting chamber 13, and a vacuum pump 43 is connected to the vacuuming pipe 42.

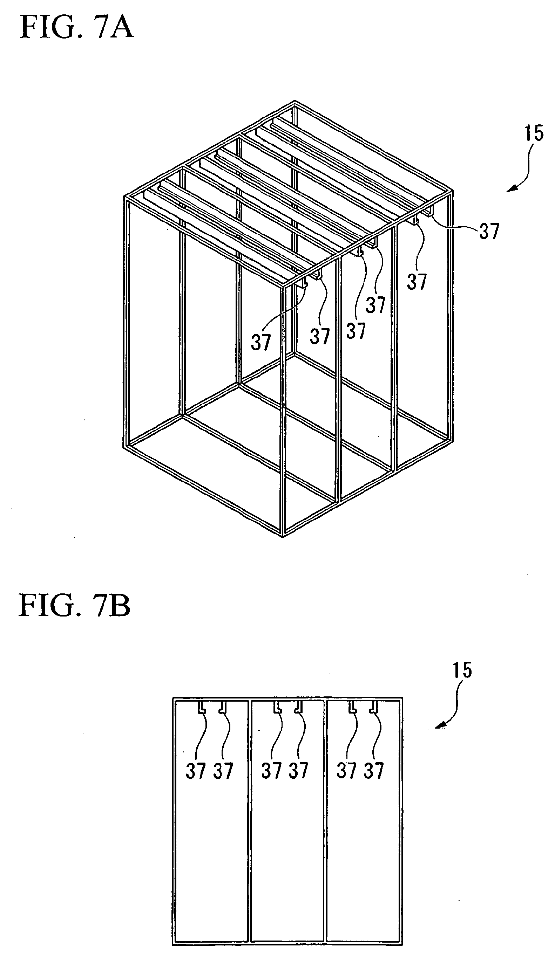

FIGS. 7A and 7B are schematic configuration views of the substrate replacement chamber 15, FIG 7A is a perspective view, and FIG. 7B is a front view. As shown in FIGS. 7A and 7B, the substrate replacement chamber 15 is made of a frame-like body, and is connected to the lateral surface 34 of the loading-ejecting chamber 13. In the substrate replacement chamber 15, the pre-film-formation-processed substrates W1 can be attached to the carrier 21 disposed at the transfer rails 37. Additionally, the post-film-formation-processed substrates W2 can also be removed from the carrier 21. Three carriers 21 are adapted to be able to be arranged in parallel at the substrate replacement chamber 15.

As shown in FIG. 2, the substrate replacement robot 17 has a drive arm 45 so that the glass substrate W can be sucked on the tip of the drive arm 45. Additionally, the drive arm 45 is adapted to be able to move between the carrier 21 disposed at the substrate replacement chamber 15, and the substrate storage holder 19 so that the pre-film-formation-processed substrate W1 can be taken out of the substrate storage holder 19, and the pre-film-formation-processed substrate W1 can be attached to the carrier 21 disposed at the substrate replacement chamber 15. Additionally, the drive arm 45 can remove the post-film-formation-processed substrate W2 from the carrier 21 which has returned to the substrate replacement chamber 15, and can also convey the substrate to the substrate storage holder 19.

FIG. 8 is a perspective view of the substrate storage holder 19. As shown in FIG 8, the substrate storage holder 19 is formed in the shape of a box, and has a size such that the holder can store a plurality of glass substrates W. A plurality of glass substrates W can be stored in a stacked manner in the up-and-down direction within the substrate storage holder 19 in a state where the surfaces to be film-formed of the substrates are made horizontal. Additionally, casters 47 are provided at four corners of a lower portion of the substrate storage holder 19 so as to allow for movement to separate processing apparatuses.

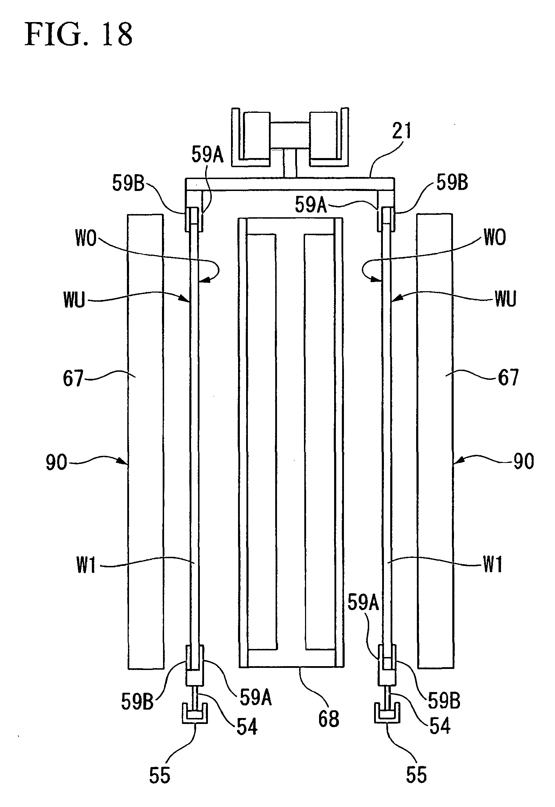

FIG. 9 is a perspective view of the carrier 21. As shown in FIG 9, the carrier 21 is provided to convey the glass substrates W, and includes two frame-like frames 51 to which the glass substrates W can be attached. That is, two glass substrates W can be attached to one carrier 21. Two frames 51 and 51 are connected together by a connection member 52 at the upper portions thereof. Additionally, the upper surface of the connection member 52 is provided with a plurality of wheels 53 placed on the transfer rails 37 so that the carrier 21 can be transferred as the wheels 53 roll on the transfer rails 37. Additionally, a lower portion of each frame 51 is provided with a frame holder 54 for suppressing the shaking of the glass substrate W when the carrier 21 is transferred. A lower end of the frame holder 54 is fitted into a rail member 55 (refer to FIG. 18) with a U-shaped cross-section on the bottom surface of each chamber. In addition, the rail members 55 are disposed along the transfer rails 37 in plan view. More stable conveyance becomes possible if the frame holder 54 is constituted by a plurality of rollers.

Each frame 51 has a peripheral edge portion 57 and a holding portion 59. The surface to be film-formed of the glass substrate W is exposed to an opening 56 formed in the frame 51. The peripheral edge portion 57 of the opening 56 and the holding portion 59 are adapted to be able to hold and fix the glass substrate W from both sides thereof. A restoring force acts on the holding portion 59 which holds the glass substrate W by a spring or the like. Additionally, as shown in FIG 21, the holding portion 59 has holding pieces 59A and 59B which contact the front surface WO (surface to be film-formed) and rear surface WU (back surface) of the glass substrate W (pre-film-formation-processed substrate W1). The gap between the holding pieces 59A and 59B is variable along the restoring direction of the spring or the like, that is, along the directions in which the holding piece 59A approaches and separates from the holding piece 59B according to the movement of the anode 67 (the details thereof will be described later). As for the carrier 21, one carrier 21 (one carrier 21 which can hold a pair (two) of substrates) is attached to one transfer rail 37.

In the thin-film solar cell manufacturing apparatus 10 of the embodiment, four sets of substrate film formation lines 16 each constituted by the film forming chamber 11, the loading-ejecting chamber 13, and the substrate replacement chamber 15 are arranged, and three carriers 21 are stored in one film forming chamber 11. Therefore, films can be substantially simultaneously formed on twenty four glass substrates W.

### (Method for Manufacturing Thin-film Solar Cell)

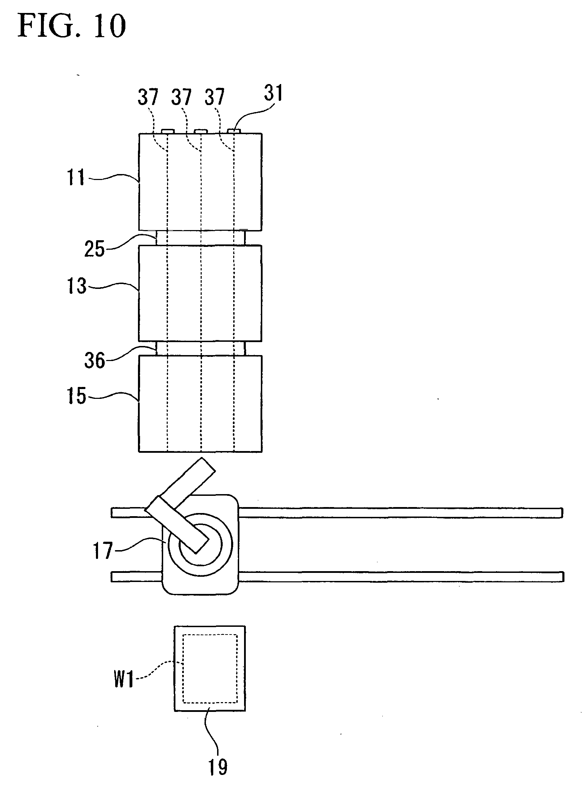

Next, a method for forming a film on a glass substrate W will be described using the thin-film solar cell manufacturing apparatus 10 of the embodiment. In addition, although drawings of a set of substrate film formation lines 16 are used in this description, 3 sets of other substrate film formation lines 16 form films on glass substrates W according to almost the same flow.
First, as shown in FIG 10, the substrate storage holder 19 which stores a plurality of pre-film-formation-processed substrates W1 is arranged at a predetermined position.

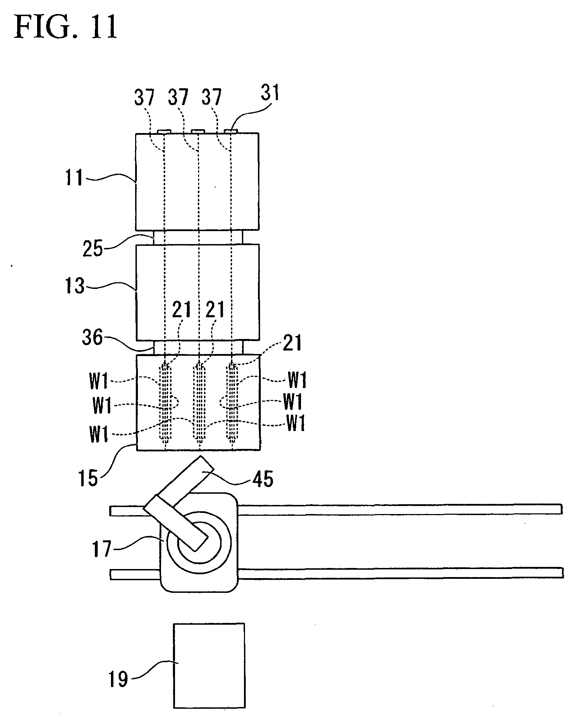

Subsequently, as shown in FIG. 11, the drive arm 45 of the substrate replacement robot 17 is operated to take one pre-film-formation-processed substrate W1 out of the substrate storage holder 19, and attaches the substrate to a carrier 21 within the substrate replacement chamber 15. At this time, the pre-film-formation-processed substrate W 1 which has been arranged horizontally on the substrate storage holder 19 is attached to the carrier 21 after its orientation is changed to the vertical direction. This operation is repeated once again to attach two pre-film-formation-processed substrates W1 to one carrier 21.
Moreover, this operation is repeated to attach the pre-film-formation-processed substrates W1 even to the remaining two carriers 21 within the substrate replacement chamber 15, respectively. That is, six pre-film-formation-processed substrates W1 are attached in this step.

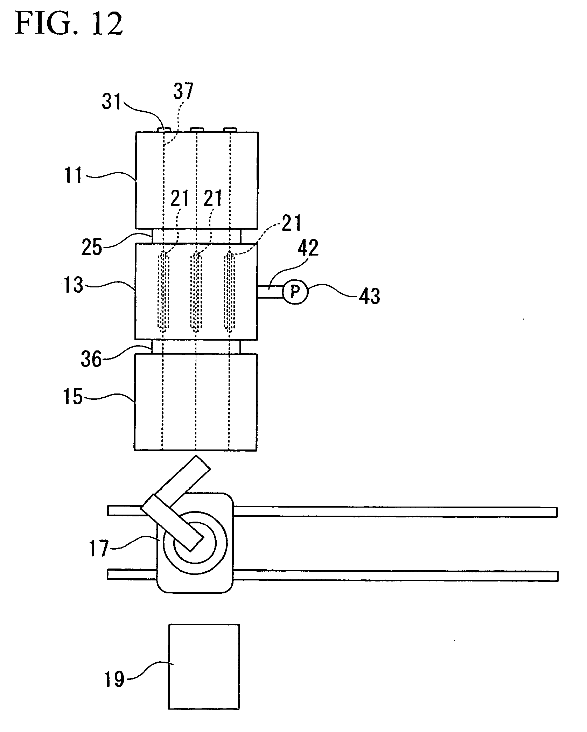

Subsequently, as shown in FIG. 12, the three carriers 21 to which the pre-film-formation-processed substrates W1 are attached are substantially simultaneously transferred along the respective transfer rails 37, and are stored within in the loading-ejecting chamber 13. After the carriers 21 are stored within the loading-ejecting chamber 13, the shutters 36 of the carrier transfer inlet ports 35 of the loading-ejecting chamber 13 are closed. Thereafter, the inside of the loading-ejecting chamber 13 is held in a vacuum state using the vacuum pump 43.

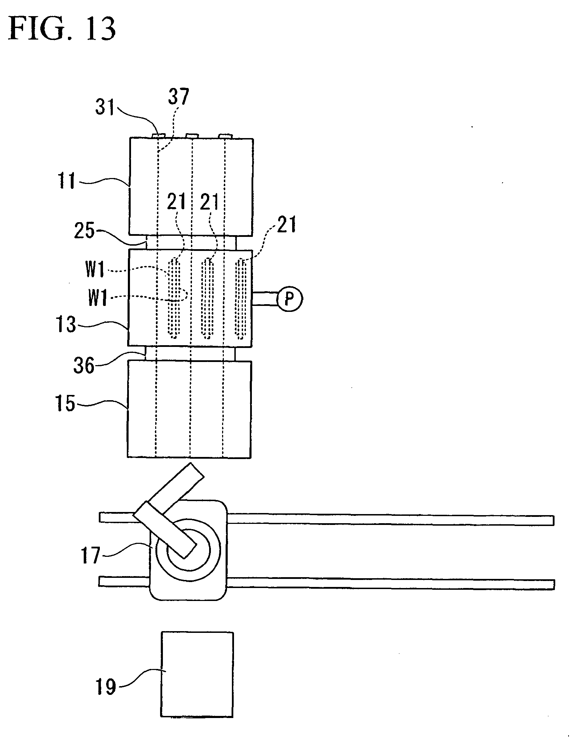

As shown in FIG 13, the three carriers 21 are transferred using the transfer mechanism by a predetermined distance, respectively, in a direction orthogonal to a direction in which the respective transfer rails 37 are laid in plan view.

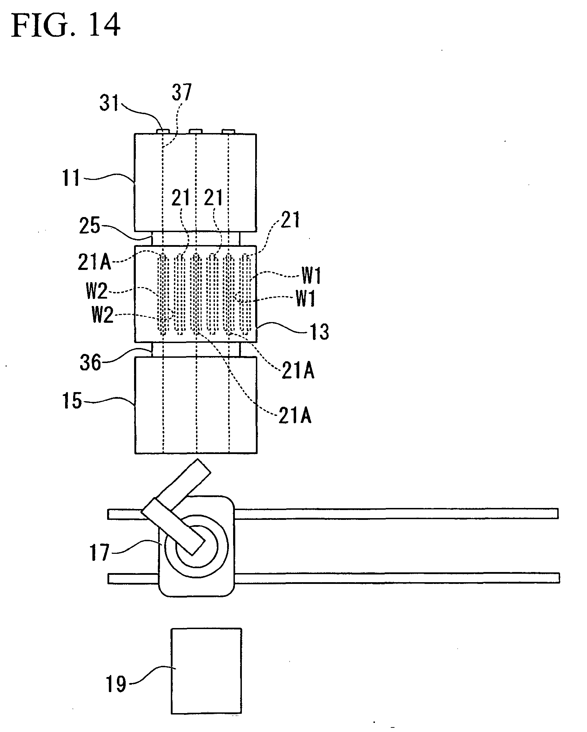

As shown in FIG 14, the shutters 25 of the film forming chamber 11 are brought into an opened state, and the carriers 21A to which the post-fllm-forrnation-processed substrates W2 of which the film forming has been ended in the film forming chamber 11 are attached are transferred into the loading-ejecting chamber 13, using the push-pull mechanism 38. At this time, the carriers 21 and the carriers 21A are alternately arranged in parallel in plan view. By holding this state for a predetermined time, the heat which is accumulated in the post-film-formation-processed substrates W2 is transferred to the pre-film-formation-processed substrates W1. That is, the pre-film-formation-processed substrates W1 are heated.

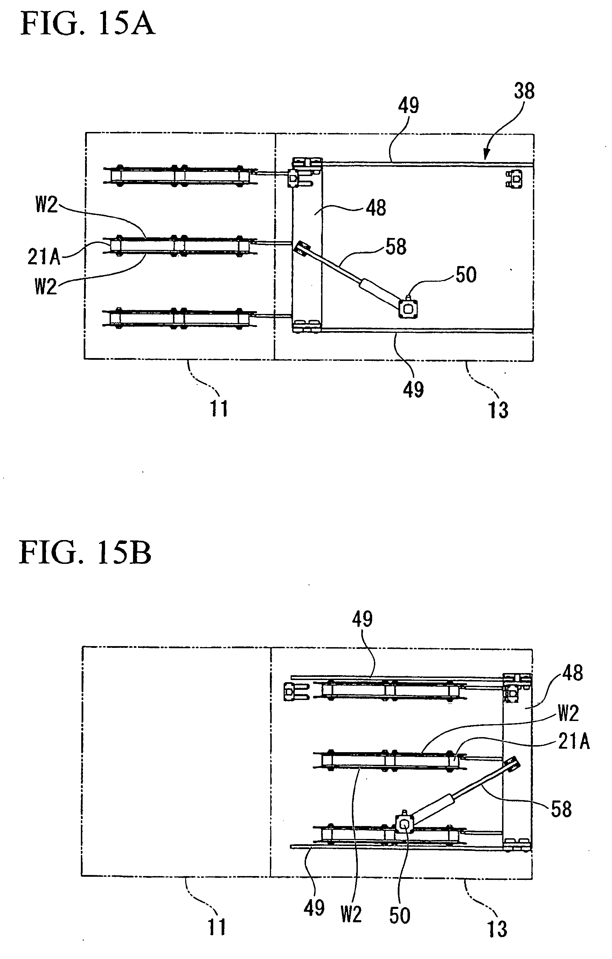

Here, the operation of the push-pull mechanism 38 will be described. In addition, the operation when the carriers 21 A within the film forming chamber 11 are transferred into the loading-ejecting chamber 13 will be described here. As shown in FIG. 15A, the carriers 21 A to which the post-film-formation-processed substrates W2 is attached are locked to the locking portion 48 of the push-pull mechanism 38. Then, the transfer arm 58 of the transfer device 50 attached to the locking portion 48 is swung. At this time, the length of the transfer arm 58 is variable. Then, the locking portion 48 to which the carriers 21A have been locked moves while being guided by the guide members 49, and as shown in FIG. 15B, moves into the loading-ejecting chamber 13. That is, the carriers 21A are transferred to the loading-ejecting chamber 13 from the film forming chamber 11. By adopting such a configuration, it becomes unnecessary to provide a drive source for transferring the carriers 21 A within the film forming chamber 11.

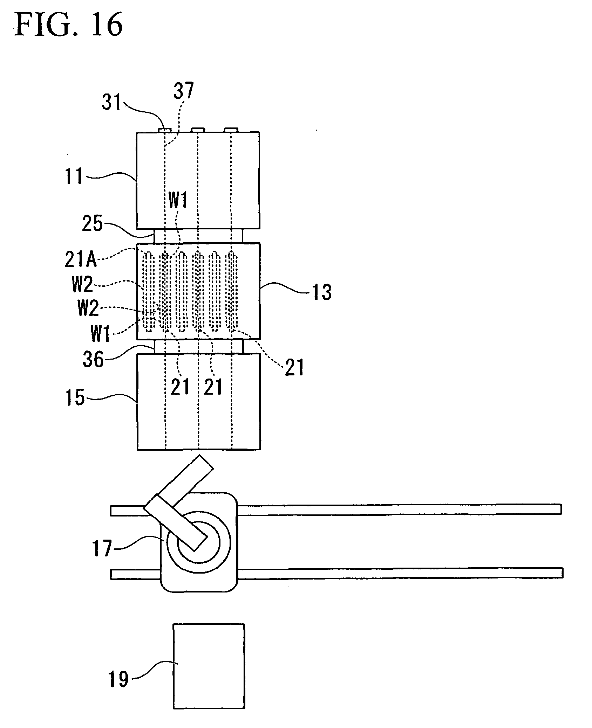

As shown in FIG 16, the carriers 21 and the carriers 21A are transferred in a direction orthogonal to the transfer rails 37 by the transfer mechanism, and the respective carriers 21 holding the pre-film-formation-processed substrates W1 are transferred to the positions of the respective transfer rails 37.

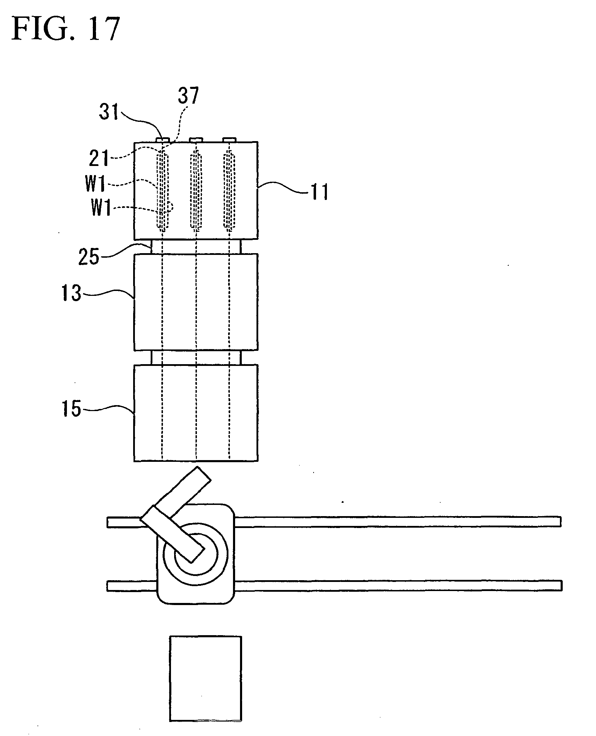

As shown in FIG. 17, the respective carriers 21 holding the pre-film-formation-processed substrates W1 are transferred into the film forming chamber 11, using the push-pull mechanism 38, and the shutters 25 are closed after the completion of transfer. In addition, the vacuum state is held within the film forming chamber 11. At this time, the pre-film-formation-processed substrates W1 attached to each carrier 21 moves along the planar direction thereof, and are inserted between the anodes 67 and the cathode unit 68 within the film forming chamber 11 so that the front surfaces WO become substantially parallel to the vertical direction (refer to FIG. 18).

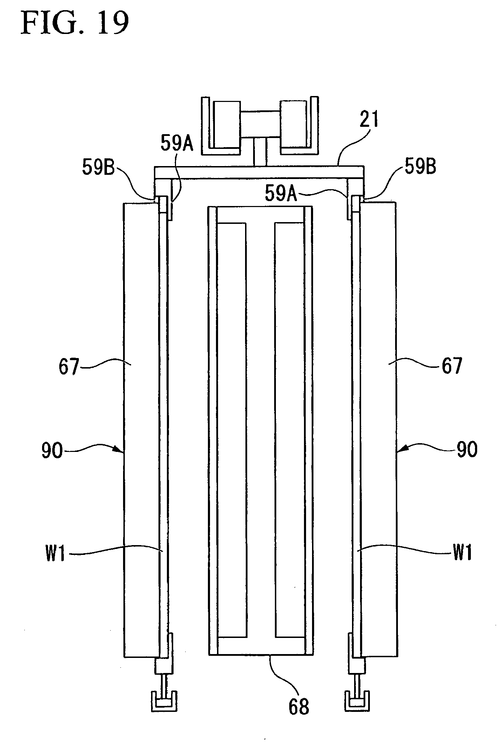

As shown in FIGS. 18 and 19, the anodes 67 are made to contact the rear surfaces WU of the pre-film-formation-processed substrates W1 by moving the two anodes 67 in directions in which the anodes 67 approach each other using the drive mechanism 71.

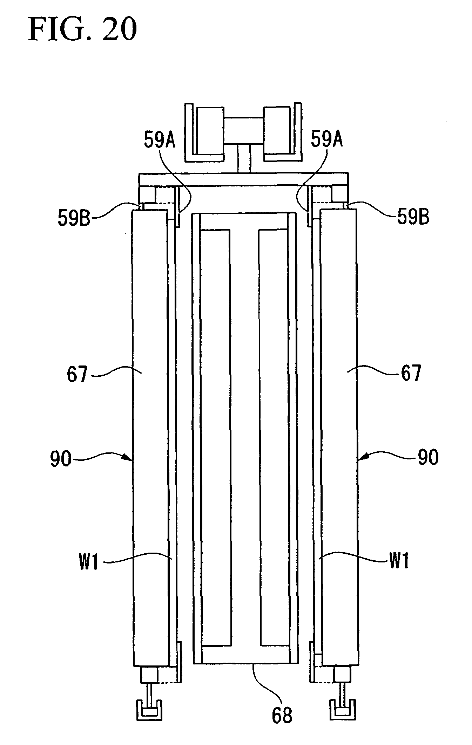

As shown in FIG. 20, when the drive mechanism 71 is further driven, the pre-film-formation-processed substrates W1 moves toward the cathode unit 68 so as to be pushed by the anodes 67. Moreover, the pre-film-formation-processed substrates W1 are moved until the gap between the pre-film-formation-processed substrate W1 and the shower plate 75 of the cathode unit 68 reaches a predetermined distance (film forming distance). In addition, this gap (film forming distance) between the pre-film-formation-processed substrate W1 and the shower plate 75 of the cathode unit 68 is within a range of 5 to 15 mm, and is preferably set to, for example, approximately 5 mm.

At this time, the holding piece 59A of the holding portion 59 of the carrier 21 which contacts the front surface WO of the pre-film-formation-processed substrate W1 is displaced in a direction away from the holding piece 59B along with the movement (movement of the anode 67) of the pre-film-formation-processed substrate W1. The pre-film-formation-processed substrate W1 at this time is held between the anode 67 and the holding piece 59A. In addition, when the anode 67 has moved toward the direction away from the cathode unit 68, since the restoring force of the spring which is not shown acts on the holding piece 59A, the holding piece 59A is displaced toward the holding piece 59B.

When the pre-film-formation-processed substrate W1 moves toward the cathode unit 68, the glass substrate W contacts the mask 78, and the movement of the anode 67 stops at this time (refer to FIG. 21).
As shown in FIG. 21, the mask 78 is formed so as to cover the outer-edge portion of the glass substrate W and come into close contact with the outer-edge portion of the glass substrate W. The film formation space 81 is partitioned and formed by the mask 78, the shower plate 75 of the cathode unit 68, and the pre-film-formation-processed substrate W1 (glass substrate W).
That is, the mask 78 separates the film formation space 81 from the space in the film forming chamber in which the carrier 21 or conveying device (not shown) exists when the carrier 21 and the glass substrate W contact each other. Moreover, a mating surface (contacting surface) between the mask 78 and the glass substrate W is constituted as a seal portion 86 so that the film forming gas does not leak out from between the mask 78 and the glass substrate W This limits the range where the film forming gas spreads, and can keep a film from being formed in an unnecessary range. As a result, since the cleaning range can be decreased and the cleaning frequency can be reduced, the operating rate of the thin-film solar cell manufacturing apparatus 10 improves.

Additionally, since the movement of the pre-film-formation-processed substrate W1 stops when the outer-edge portion thereof contacts the mask 78, the gap between the mask 78 and the shower plate 75 or the discharge duct 79, that is, the flow passage dimension of the gas flow passage R in the thickness direction is set so that the gap between the pre-film-formation-processed substrate W1 and the cathode unit 68 reaches a predetermined distance.
As another form, the distance between the pre-film-formation-processed substrate W1 and the shower plate 75 (=cathode unit 68) can also be optionally changed by the stroke of the drive mechanism 71 by attaching the mask 78 to the discharge duct 79 via an elastic body. In the above embodiment, the mask 78 and the pre-film-formation-processed substrate W1 contacts each other. However, the mask 78 and the pre-film-formation-processed substrate W1 may be arranged so as to leave a very small gap which limits the passage of the film forming gas.

Subsequently, the film forming gas is jetted from the shower plate 75 of the cathode unit 68, and the matching box 72 is started to apply a voltage to the cathode 76 of the cathode unit 68, thereby generating plasma within the film formation space 81 to form a film on the front surface WO of the pre-film-formation-processed substrate W1. At this time, the pre-film-formation-processed substrate W1 is heated to a desired temperature by the heater H built in the anode 67.

The anode 67 stops heating when the pre-film-formation-processed substrate W1 reaches a desired temperature. Meanwhile, plasma is generated within the film formation space 81 by applying a voltage to the shower plate 75 (=cathode unit 68). Even if the heating of the anode 67 is stopped, there is a possibility that the temperature of the pre-film-formation-processed substrate W1 may rise higher than a desired temperature due to the heat input from the plasma with the passage of time. In this case, the anode 67 can also be made to function as a radiator plate for cooling the pre-film-formation-processed substrate W1 where the temperature has risen excessively. Accordingly, the temperature of the pre-film-formation-processed substrate W1 is adjusted to a desired temperature irrespective of the passage of the film formation processing time.
In addition, when a plurality of layers is film-formed through one film formation processing process, this film formation can be performed by switching the film forming gas material to be supplied at each predetermined time.

During film forming and after film forming, the gas or reactive by-products (powder) within the film formation space 81 is evacuated from the vacuuming ports 80 formed in the peripheral edge portion of the cathode unit 68. The gas to be evacuated passes through the discharge duct 79 of the peripheral edge portion of the cathode unit 68, and is evacuated to the outside from the vacuuming pipe 29 provided at the lateral lower portion 28 of the film forming chamber 11. In addition, the reactive by-products (powder) generated when a film is formed can be collected and disposed of when being made to adhere to and deposit on the inner wall surface of the discharge duct 79. Since the same processing as the above-described processing is performed in all the electrode units 31 in the film forming chamber 11, film formation processing can be simultaneously performed on all six substrates.

When the film formation processing is ended, the two anodes 67 are moved in directions away from each other by the drive mechanism 71, and the post-film-formation-processed substrates W2 and the frames 51 (holding pieces 59A) are returned to their original positions (refer to FIGS. 19 and 21). That is, when the film formation processing is ended and the carrier 21 is transferred, the masks 78 are removed through exposure surfaces 85 of the holding pieces 59A.
Moreover, by moving the anodes 67 in directions away from each other, the post-film-formation-processed substrates W2 and the anodes 67 are separated from each other (refer to FIG. 18).

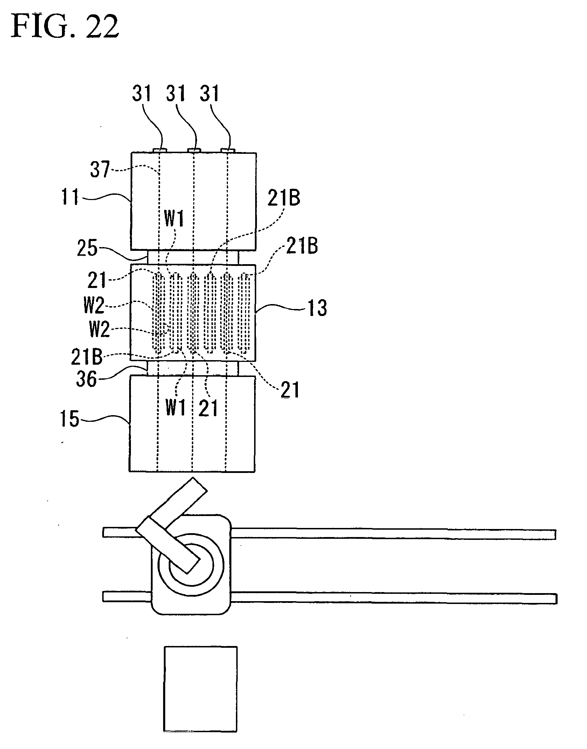

As shown in FIG. 22, the shutters 25 of the film forming chamber 11 are opened, and each carrier 21 is transferred into the loading-ejecting chamber 13, using the push-pull mechanism 38. At this time, the inside of the loading-ejecting chamber 13 is evacuated, and the carriers 21B to which the pre-film-formation-processed substrates W1 to be film-formed next are attached are already arranged. Then, the heat accumulated in the post-film-formation-processed substrates W2 is transferred to the pre-film-formation-processed substrates W1 within the loading-ejecting chamber 13, and the temperature of the post-film-formation-processed substrates W2 is lowered.

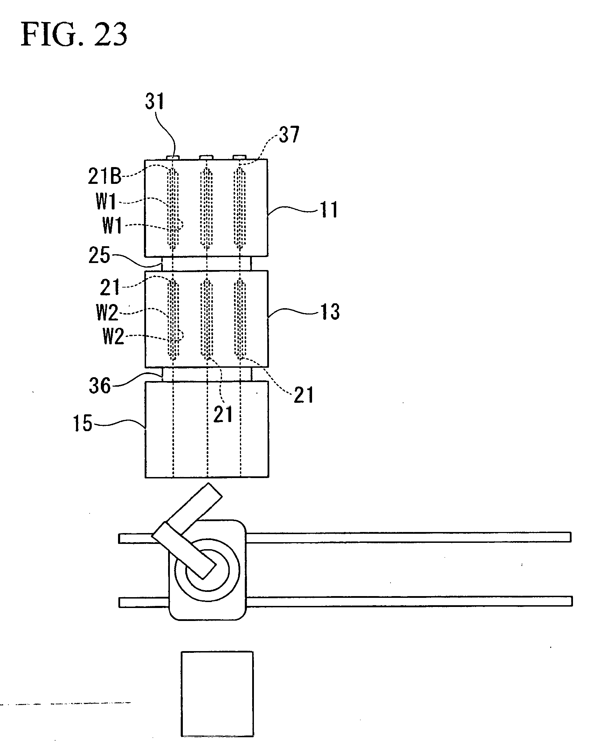

As shown in FIG 23, after each carrier 21B is transferred into the film forming chamber 11, each carrier 21 is returned to the position of the transfer rails 37 by the transfer mechanism.

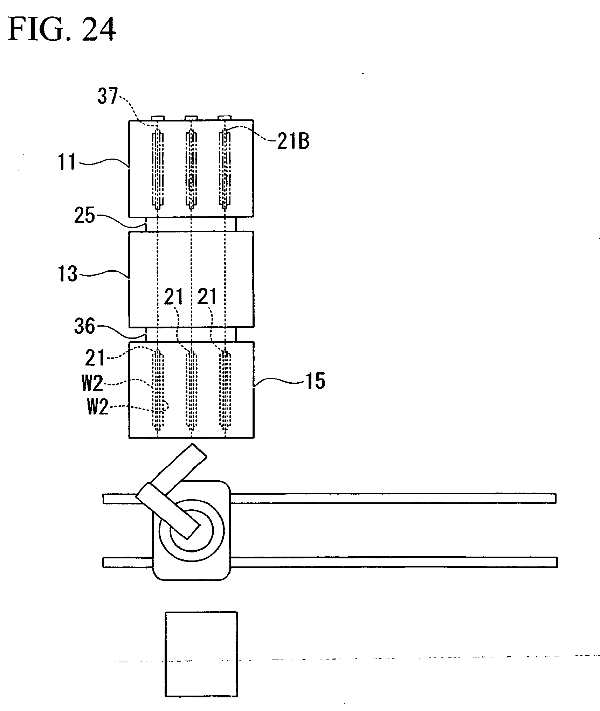

As shown in FIG. 24, after the shutters 25 are closed, the inside of the loading-ejecting chamber 13 is brought to atmospheric pressure, the shutters 36 are opened, and the carriers 21 are transferred into the substrate replacement chamber 15.

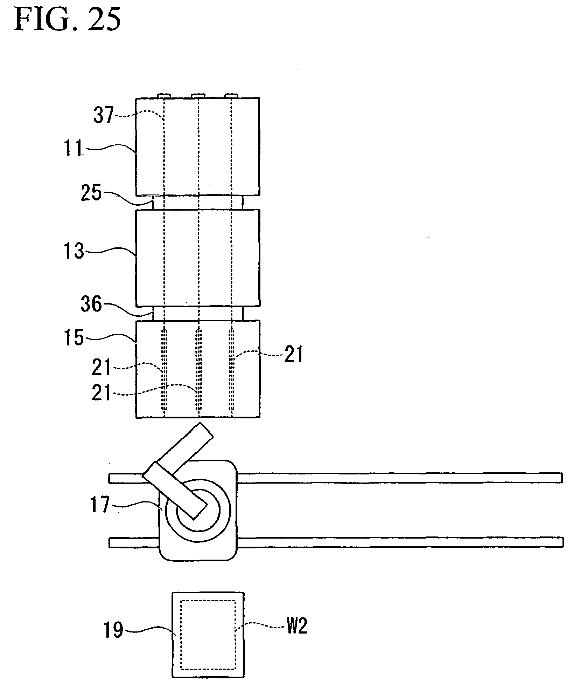

As shown in FIG 25, each post-film-formation-processed substrate W2 is removed from each carrier 21 by the substrate replacement robot 17 within the substrate replacement chamber 15, and is transferred to the substrate storage holder 19. When removal of all the post-film-formation-processed substrates W2 is completed, the film formation processing is ended by moving the substrate storage holder 19 to a place for the following process.

### (Maintenance work on Electrode Unit)

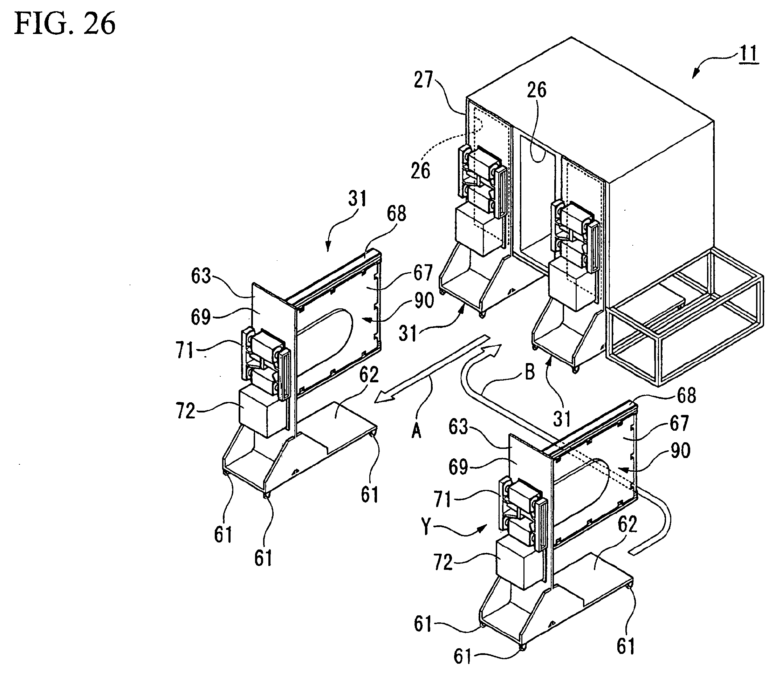

Next, the procedure of maintenance work on the electrode units 31 in the thin-film solar cell manufacturing apparatus 10 of the embodiment will be described referring to FIGS. 4A and 26. In addition, in this description, the procedure of maintenance work on one electrode unit 31 (middle electrode unit 31 in FIG. 26) among three electrode units 31 attached to one film forming chamber 11 will be described as an example, and description of maintenance work on the other electrode units 31 is omitted. However, it goes without saying that the maintenance work on the other electrode units 31 is also performed through the same procedure.

When a film is formed on or a reactive by-products (powder) adheres to the cathode unit 68 or anode unit 90 of the electrode unit 31 which is attached within the film forming chamber 11, as shown in FIG. 26, the cathode unit 68 and the anode unit 90 are removed, and maintenance work, such as the cleaning or replacement thereof, is performed.
In order to perform the maintenance work, first, the electrode unit 31 is moved in a pull-out direction (the direction of arrow A in FIG. 26), and the electrode unit 31 is separated from the film forming chamber 11. At this time, since the side plate portion 63 of the electrode unit 31 constitutes a part of a wall surface of the film forming chamber 11, the opening 26 of the film forming chamber 11 is opened when the side plate portion 63 separates from the film forming chamber 11.

Then, the auxiliary unit Y is mounted to the opening 26 (refer to arrow B in FIG. 26). The auxiliary unit Y has the same configuration as the electrode unit 31.
That is, the auxiliary unit Y has the side plate portion 63 which blocks the opening 26 of the film forming chamber 11, and the cathode unit 68, and the anode unit 90 (anodes 67) located on both sides of the cathode unit 68 are arranged at the side plate portion 63. In addition, the configuration of the auxiliary unit Y is the same as that of the electrode unit 31 in that the auxiliary unit Y has the drive mechanism 71 for driving the anodes 67, and in that the hinge portions 87 which allows the anodes 67 to be opened and closed with respect to the cathode unit 68 are provided at the anodes 67 on the side of the side plate portion 63.

Accordingly, the opening 26 of the film forming chamber 11 is closed by mounting the auxiliary unit Y on the opening 26 of the film forming chamber 11. For this reason, if the auxiliary unit Y is used while maintenance (cleaning) of the electrode unit 31 is performed, the thin-film solar cell manufacturing apparatus 10 can be used. For this reason, the operating rate of the thin-film solar cell manufacturing apparatus 10 can be increased. In addition, the operation of forming a film on the front surface WO of the pre-film-formation-processed substrate W1 can be resumed again, without lowering the temperature within the film forming chamber 11 to a desired temperature required for maintenance work. For this reason, it is possible to shorten the cooling time of the film forming chamber 11 required for maintenance work.

Meanwhile, the electrode unit 31 separated from the film forming chamber 11 is left to a maintainable temperature in a state where the electrode unit 31 is exposed to the ambient air as a single body.
When the electrode unit 31 falls to a desired temperature, as shown in FIG. 4A, the anode unit 90 is turned about the hinge portion 87. Then, the respective facing surfaces of the anode unit 90 and the cathode unit 68 are simultaneously exposed.

When a film is formed, the film formation space 81 is formed by the mask 78, the shower plate (=cathode) 75 of the cathode unit 68, and the glass substrate W In many cases, a film may be formed on or a reactive by-products (powder) may adhere to the surface (shower plate 75) of the cathode unit 68 which faces the anode unit 90, and the surface 67A (refer to FIG. 4D) of the anode unit 90 which faces the cathode unit 68. Additionally, a film or reactive by-products (powder) adheres even to the mask 78 or gas flow passage R. For this reason, cleaning of each surface, or replacement of the shower plate 75, the mask 78, or the like can be easily performed by opening the anode unit 90. Then, when the cleaning or replacement of respective parts of the electrode unit 31 is ended, the maintenance work is ended. The discharge duct 79 installed in the electrode unit 31 can also be simultaneously pulled out of the film forming chamber 13. For this reason, the reactive by-products (powder) adhered to and deposited on the discharge duct 79 can also be easily maintained (cleaned).

The electrode unit 31 of which the maintenance has been completed functions as the auxiliary unit Y after this. That is, when another electrode unit 31 mounted to the film forming chamber 11 is maintained, the another electrode unit 31 is separated from the film forming chamber 11, and the electrode unit 31 (auxiliary unit Y) of which the maintenance has been completed is then mounted to the opening 26 opened by this separation. By repeating this, the thin-film solar cell manufacturing apparatus 10 can be operated without being almost stopped even if the maintenance is performed.

Accordingly, according to the embodiment, the electrode unit 31 having the cathode 76 and the anodes 67 can be easily separated from the film forming chamber 11. For this reason, maintenance work can be performed on the electrode unit 31 as a single body, and it is possible to secure a large working space. Hence, it is possible to reduce the burden of the maintenance work.
Additionally, in the electrode unit 31 as a single body separated from the film forming chamber 11, it is possible to adjust the separation distance between the anode unit 90 (anodes 67) and the cathode unit 68 which contacts the glass substrate W during film formation processing, or to connect a dummy load to the cathode 76 and the anodes 67, thereby adjusting the impedances of the cathode 76 and the anodes 67. For this reason, various adjustments required to operate the thin-film solar cell manufacturing apparatus 10 can be performed off-line.

Moreover, the respective facing surfaces of the anode unit 90 (or anode 67) and the cathode unit 68 (or cathode 76) can be exposed by the hinge portion 87. For this reason, it becomes easy to perform maintenance work, and the burden of the maintenance work can be further reduced.
Since the hinge portion 87 is provided at the anode 67 on the side of the side plate portion 63, the hinge portion 87 can be turned (opened) until the surface 67A of the anode 67 on the side of the cathode unit 68 becomes substantially parallel to one surface 65 of the side plate portion 63. That is, the respective facing surfaces of the anode 67 and the cathode 76 can be exposed. Thereby, the respective facing surfaces of the anode 67 and the cathode 76 on which a film is often formed except the glass substrate W can be exposed. Hence, it is possible to further reduce the burden of the maintenance work. Moreover, since the hinge portion can be opened and closed while being attached to the side plate portion 63, maintenance becomes possible without removing the anode 67 and the cathode 76 from the side plate portion 63.

Additionally, even when the electrode unit 31 is separated from the film forming chamber 11 in order to perform maintenance work, the thin-film solar cell manufacturing apparatus 10 can be normally operated until the auxiliary unit Y is mounted to the film forming chamber 11 instead of the electrode unit 31, and thereby, the maintenance work on the electrode unit 31 is ended. Moreover, since the auxiliary unit Y has the same configuration as the electrode unit 31, appropriate film forming can be performed on the glass substrate W even if the auxiliary unit Y is mounted to the film forming chamber 11. For this reason, even if maintenance work is performed, a decrease in production efficiency can be prevented.

Moreover, the two anodes 67 are moved in the directions in which the anodes 67 approach each other by the drive mechanism 71 when film formation processing is performed, whereby the anodes 67 and the rear surfaces WU of the pre-film-formation-processed substrate W1 are made to contact each other, and the drive mechanism 71 is driven to transfer the pre-film-formation-processed substrates W1 toward the cathode unit 68 so as to be pushed by the anodes 67. Moreover, the heater H is built in the anode 67, and the anode 67 and the heater H constitutes the anode unit 90. For this reason, since nothing is interposed between the anode 67 and the glass substrate W when film formation processing is performed, the glass substrate W can be efficiently heated. Additionally, since it becomes unnecessary to separately provide the heater H, the thin-film solar cell manufacturing apparatus 10 can also be miniaturized.

Since the shower plates 75 and 75 form the cathodes (high-frequency electrode) connected to the matching box 72, it becomes unnecessary to separately provide the cathodes and the shower plates 75. Hence, it is possible to achieve simplification or lower costs of the thin-film solar cell manufacturing apparatus 10. Additionally, uniform introduction of the film forming gas into the film formation space 81 and uniform generation of plasma become possible.
Additionally, since the anodes 67 move along the directions in which the anodes 67 approach to and separate from the cathode (shower plate 75), the gap between the anodes 67 and the cathode (shower plate 75) can be set to a long distance when the glass substrate W enters and exits the film forming chamber 11. Meanwhile, when a Si-layer is film-formed on the glass substrate W by the plasma-CVD method, the gap between the pre-film-formation-processed substrate W1 and the shower plate 75 of the cathode unit 68 can be set to a predetermined short distance (film forming distance). Specifically, this predetermined distance can be set to approximately 5 mm. For this reason, it is possible to facilitate entrance and exit of the glass substrate W from the film forming chamber 11 while improving the quality of film forming, and it is possible to improve productivity. Additionally, when the glass substrate W enters and exits the film forming chamber 11, it is possible to prevent the glass substrate W from contacting and being damaged by the anode 67 or the cathode unit 68.

Moreover, since the mask 78 is provided at the peripheral edge portion of the cathode unit 68 so as to cover the part from the peripheral portion of the discharge duct 79 to the peripheral portion of the shower plate 75 (=cathode), the film formation range of the outer-edge portion of the glass substrate W can be limited. For this reason, formation of a film on a portion where film forming is unnecessary on the surface to be film-formed of the glass substrate W, that is, the outer-edge portion of the glass substrate W, can be prevented. Since the mask 78 can be separated from the film forming chamber 11 integrally with the electrode unit 31, cleaning of the mask 78 becomes easy.

It should be understood that the technical scope of the present invention is not limited to only the above-described embodiment, but that various modifications of the above-described embodiment may be made without departing from the scope of the present invention. That is, the specific shapes and configurations as mentioned in the embodiment are merely examples, and can be appropriately changed.
Moreover, the case where the glass substrates W are respectively arranged on both sides of the cathode unit 68 so as to face the cathode unit in a state where the glass substrates W become substantially parallel to the vertical direction; the two anodes 67 are arranged outside the respective glass substrates W in the thickness direction in a state where the anodes 67 face the glass substrates W, respectively; and the cathode unit 68 is provided with the masks 78 has been described in the above-described embodiment. However, the present invention is not limited to only this configuration. A configuration may be adopted in which the glass substrates W are respectively arranged both sides of the anode unit 90 having the anodes 67, a pair of cathodes 76 is disposed outside the glass substrates W, and the cathodes 76 are provided with the masks 78, respectively.

Additionally, the case where the hinge portion 87 is provided at the anode 67 on the side of the side plate portion 63 as an opening and closing unit which can simultaneously expose the surface 67A of the anode unit 90 (anode 67), and the surface (shower plate 75) of the cathode unit 68 which faces the anode unit 90 has been described in the above-described embodiment. However, the present invention is not limited to this only. For example, if there is a margin in the height direction in a place where the installation space of the thin-film solar cell manufacturing apparatus 10 can be secured, specifically, in a place where the thin-film solar cell manufacturing apparatus 10 is installed, the hinge portion 87 may be provided at an upper portion or lower portion of the electrode unit 31 in the height direction. Moreover, as long as the respective facing surfaces of the anode 67 and the cathode unit 68 can be exposed, the anode unit 90 (anode 67) can be provided so as to be slidable with respect to the cathode unit 68.

According to the present invention, the electrode unit having the cathode and the anodes can be easily separated from the film forming chamber. For this reason, maintenance work can be performed on the electrode unit as a single body, and it is possible to secure a large working space. Hence, it is possible to reduce the burden of the maintenance work.
Additionally, even if the electrode unit is separated from the film forming chamber in order to perform maintenance work, the auxiliary unit can be mounted to the film forming chamber, instead of the electrode unit. In this case, the thin-film solar cell manufacturing apparatus can be normally operated until the maintenance work on the electrode unit is ended. Moreover, since the auxiliary unit has the same configuration as the electrode unit, appropriate film forming can be performed on the substrate. For this reason, even if the maintenance work is performed, a decrease in production efficiency can be prevented.

### [Reference Symbol List]

- 10:: THIN-FILM SOLAR CELL MANUFACTURING APPARATUS
- 11:: FILM FORMING CHAMBER
- 27:: LATERAL SURFACE
- 31:: ELECTRODE UNIT
- 61:: WHEEL (CARRIER)
- 62:: BOTTOM PLATE PORTION (CARRIER)
- 63:: SIDE PLATE PORTION
- 67:: ANODE
- 67A:: SURFACE
- 68:: CATHODE UNIT
- 75:: CATHODE ALSO SERVING AS SHOWER PLATE
- 76:: CATHODE INTERMEDIATE MEMBER
- 78:: MASK (MASK UNIT)
- 87:: HINGE PORTION (OPENING AND CLOSING UNIT)
- 90:: ANODE UNIT
- 102:: TOP CELL (FILM)
- 104:: BOTTOM CELL (FILM)
- H:: HEATER (TEMPERATURE CONTROL UNIT)
- R:: GAS FLOW PASSAGE
- W:: SUBSTRATE
- W1:: PRE-FILM-FORMATION-PROCESSED SUBSTRATE
- W2:: POST-FILM-FORMATION-PROCESSED SUBSTRATE
- WO:: SURFACE (SURFACE TO BE FILM-FORMED)
- Y:: AUXILIARY UNIT

## Claims

1. A thin-film solar cell manufacturing apparatus (1) comprising: a film forming chamber (11) which stores a substrate (W); and an electrode unit (31) which performs film formation using a CVD method on the substrate (W) in the film forming chamber (11),
wherein the electrode unit (31) has:
an anode (67) and a cathode (75); and
a side plate portion (63) which holds the anode (67) and the cathode (75) and forms a part of a wall portion (27) of the film forming chamber (11), and is attachable to and detachable from the film forming chamber (11).

2. The thin-film solar cell manufacturing apparatus (1) according to claim 1, comprising the cathode (75) and a pair of the anodes (67),
wherein the respective anodes (67) are arranged so as to face the cathode (75) at a predetermined distance from the cathode (75).

3. The thin-film solar cell manufacturing apparatus (1) according to claim 1 or 2,
wherein the electrode unit (31) further includes an opening and closing unit (87) for changing the opening angle of the anode (67) with respect to the cathode (75).

4. The thin-film solar cell manufacturing apparatus (1) according to claim 3,
wherein the opening and closing unit (87) is provided at the anode (67) on the side of the side plate portion (63).

5. The thin-film solar cell manufacturing apparatus (1) according to any one of claims 1 to 4, further comprising an auxiliary unit (Y) having the same configuration as the electrode unit (31).

6. The thin-film solar cell manufacturing apparatus (1) according to any one of claims 1 to 5,
wherein a temperature control unit (H) for adjusting a heating temperature of the substrate (W) is built into the anode (67), and the temperature control unit (H) and the anode (67) constitutes the anode unit (90).

7. The thin-film solar cell manufacturing apparatus (1) according to any one of claims 1 to 6,
wherein the cathode (75) and the anode (67)are attached so as to be substantially perpendicular to the side plate portion (63) in plan view,
a wall portion (27) of the film forming chamber (11) is provided with an opening (26), and
the electrode unit (31) is attached to the film forming chamber (11) when the cathode (75) and the anode (67) are inserted into the film forming chamber (11) through the opening (26) and the side plate portion (63) closes the opening (26).

8. The thin-film solar cell manufacturing apparatus (1) according to any one of claims 1 to 6,
wherein the cathode (75) and the anode (67) are attached so as to be substantially perpendicular to the side plate portion (63) in plan view,
the wall portion (27) of the film forming chamber (11) is provided with an opening (26) which is closed by the side plate portion (63), and
the cathode (75) and the anode (67) are detached to the outside of the film forming chamber (11) through the opening (26) by removing the side plate portion (63) closing the opening (26).

9. The thin-film solar cell manufacturing apparatus (1) according to any one of claims 1 to 8,
wherein the electrode unit (31) further includes a driving unit (71) which allows the anode (67) to approach to and separate from the cathode (75).

10. The thin-film solar cell manufacturing apparatus (1) according to any one of claims 1 to 9,
wherein the cathode (75) is a shower plate which supplies film forming gas to a surface to be film-formed of the substrate (W), and the side plate portion (63) has an introducing portion into which the film forming gas is introduced.

11. The thin-film solar cell manufacturing apparatus (1) according to any one of claims 1 to 10,
wherein the electrode unit (31) further includes a mask unit (78) which limits a film formation range at the outer-edge portion of the substrate (W).

12. The thin-film solar cell manufacturing apparatus (1) according to any one of claims 1 to 11,
wherein the electrode unit (31) further includes a truck (62A).

13. The thin-film solar cell manufacturing apparatus (1) according to claim 12,
wherein the truck (62A) is capable of being connected to and separated from the side plate portion (63).

## Patentansprüche

1. Vorrichtung (1) zur Herstellung einer Dünnfilmsolarzelle, umfassend:
eine Filmbildungskammer (11), die ein Substrat (W) aufnimmt; und
eine Elektrodeneinheit (31), die eine Filmbildung mittels eines CVD-Verfahrens auf dem Substrat (W) in der Filmbildungskammer (11) ausführt,
wobei die Elektrodeneinheit (31) aufweist:
eine Anode (67) und eine Kathode (75); und
einen Seitenplattenabschnitt (63), der die Anode (67) und die Kathode (75) hält und einen Teil eines Wandabschnitts (27) der Filmbildungskammer (11) bildet, und der an der Filmbildungskammer (11) anbringbar und von der Filmbildungskammer (11) abnehmbar ist.

2. Vorrichtung (1) zur Herstellung einer Dünnfilmsolarzelle nach Anspruch 1,
umfassend die Kathode (75) und ein Paar der Anoden (67),
wobei die jeweiligen Anoden (67) so angeordnet sind, dass sie der Kathode (75) in einem vorbestimmten Abstand von der Kathode (75) gegenüberstehen.

3. Vorrichtung (1) zur Herstellung einer Dünnfilmsolarzelle nach Anspruch 1 oder 2,
wobei die Elektrodeneinheit (31) des Weiteren eine Öffnungs- und Schließeinheit (87) zum Verändern des Öffnungswinkels der Anode (67) in Bezug auf die Kathode (75) umfasst.

4. Vorrichtung (1) zur Herstellung einer Dünnfilmsolarzelle nach Anspruch 3,
wobei die Öffnungs- und Schließeinheit (87) an der Anode (67) auf der Seite des Seitenplattenabschnitts (63) bereitgestellt ist.

5. Vorrichtung (1) zur Herstellung einer Dünnfilmsolarzelle nach einem der Ansprüche 1 bis 4,
des Weiteren umfassend eine zusätzliche Einheit (Y), die dieselbe Konfiguration wie die Elektrodeneinheit (31) aufweist.

6. Vorrichtung (1) zur Herstellung einer Dünnfilmsolarzelle nach einem der Ansprüche 1 bis 5,
wobei eine Temperatursteuereinheit (H) zum Einstellen einer Heiztemperatur des Substrates (W) in die Anode (67) eingebaut ist, und die Temperatursteuereinheit (H) und die Anode (67) die Anodeneinheit (90) bilden.

7. Vorrichtung (1) zur Herstellung einer Dünnfilmsolarzelle nach einem der Ansprüche 1 bis 6,
wobei die Kathode (75) und die Anode (67) so angebracht sind, dass sie im Wesentlichen senkrecht zu dem Seitenplattenabschnitt (63) in der Draufsicht sind,
ein Wandabschnitt (27) der Filmbildungskammer (11) mit einer Öffnung (26) versehen ist, und
die Elektrodeneinheit (31) an der Filmbildungskammer (11) angebracht wird, wenn die Kathode (75) und die Anode (67) in die Filmbildungskammer (11) durch die Öffnung (26) eingebracht werden und der Seitenplattenabschnitt (63) die Öffnung (26) verschließt.

8. Vorrichtung (1) zur Herstellung einer Dünnfilmsolarzelle nach einem der Anspruche 1 bis 6,
wobei die Kathode (75) und die Anode (67) so angebracht sind, dass sie im Wesentlichen senkrecht zu dem Seitenplattenabschnitt (63) in der Draufsicht sind,
ein Wandabschnitt (27) der Filmbildungskammer (11) mit einer Öffnung (26) versehen ist, die durch den Seitenplattenabschnitt (63) verschlossen wird, und
die Kathode (75) und die Anode (67) zu der Außenseite der Filmbildungskammer (11) durch die Öffnung (26) abgenommen werden durch Entfernen des Seitenplattenabschnitts (63), der die Öffnung (26) verschließt.

9. Vorrichtung (1) zur Herstellung einer Dünnfilmsolarzelle nach einem der Ansprüche 1 bis 8,
wobei die Elektrodeneinheit (31) des Weiteren eine Antriebseinheit (71) beinhaltet, die es der Anode (67) ermöglicht, sich der Kathode (75) zu nähern und sich von der Kathode (75) zu trennen.

10. Vorrichtung (1) zur Herstellung einer Dünnfilmsolarzelle nach einem der Ansprüche 1 bis 9,
wobei die Kathode (75) eine Brauseplatte ist, die ein Filmbildungsgas auf einer Oberfläche des Substrats (W), auf der ein Film gebildet werden soll, bereitstellt, und der Seitenplattenabschnitt (63) einen Einleitungsabschnitt aufweist, in den das Filmbildungsgas eingeleitet wird.

11. Vorrichtung (1) zur Herstellung einer Dünnfilmsolarzelle nach einem der Ansprüche 1 bis 10,
wobei die Elektrodeneinheit (31) des Weiteren eine Maskeneinheit (78) beinhaltet, die einen Filmbildungsbereich an dem äußeren Kantenabschnitt des Substrats (W) begrenzt.

12. Vorrichtung (1) zur Herstellung einer Dünnfilmsolarzelle nach einem der Ansprüche 1 bis 11,
wobei die Elektrodeneinheit (31) des Weiteren einen Rollwagen (62A) beinhaltet.

13. Vorrichtung (1) zur Herstellung einer Dünnfilmsolarzelle nach Anspruch 12,
wobei der Rollwagen (62A) in der Lage ist, mit dem Seitenplattenabschnitt (63) verbunden und von dem Seitenplattenabschnitt (63) getrennt zu werden.

## Revendications

1. Dispositif (1) de fabrication d'une cellule solaire à couche mince comprenant : une chambre (11) de formation d'un film qui reçoit un substrat (W) ; et une unité (31) d'électrode qui effectue une formation de film en utilisant un procédé CVD sur le substrat (W) dans la chambre (11) de formation de film,
dans lequel l'unité (31) d'électrode a :
une anode (67) et une cathode (75) ; et
une partie (63) de plaque latérale, qui maintient la cathode (67) et l'anode (75), qui forme une pièce d'une partie (27) de paroi de la chambre (11) de formation de film et qui peut être montée sur la chambre (1) de formation de film et en être démontée.

2. Dispositif (1) de fabrication d'une cellule solaire à couche mince suivant la revendication 1,
comprenant la cathode (75) et une paire des anodes (67),
dans lequel les anodes (67) respectives sont montées de manière à faire face à la cathode (75) à une distance déterminée à l'avance de la cathode (75).

3. Dispositif (1) de fabrication d'une cellule solaire à couche mince suivant la revendication 1 ou 2,
dans lequel l'unité (31) de l'électrode comprend en outre une unité (87) d'ouverture et de fermeture pour modifier l'angle d'ouverture de l'anode (67) par rapport à la cathode (75).

4. Dispositif (1) de fabrication d'une cellule solaire à couche mince suivant la revendication 3,
dans lequel l'unité (87) d'ouverture et de fermeture est prévu à l'anode (67) du côté de la partie (63) de plaque latérale.

5. Dispositif (1) de fabrication d'une cellule solaire à couche mince suivant l'une quelconque des revendications 1 à 4 comprenant, en outre, une unité (Y) auxiliaire ayant la même configuration que l'unité (31) d'électrode.

6. Dispositif (1) de fabrication d'une cellule solaire à couche mince suivant l'une quelconque des revendications 1 à 5,
dans lequel une unité (H) de réglage de la température pour régler une température de chauffage du substrat (W) est constituée dans l'anode (67) et l'unité (H) de commande de la température et l'anode (67) constituent l'unité (90) d'anode.

7. Dispositif (1) de fabrication d'une cellule solaire à couche mince suivant l'une quelconque des revendications 1 à 6,
dans lequel la cathode (75) et l'anode (67) sont montées de manière à être sensiblement perpendiculaires à la partie (63) de plaque latérale en vue en plan,
une partie (27) de paroi de la chambre (11) de formation de film est pourvue d'une ouverture (26), et
l'unité (31) d'électrode est montée sur la chambre (11) de formation de film lorsque la cathode (75) et l'anode (67) sont insérées dans la chambre (11) de formation de film par l'ouverture (26) et la partie (63) de plaque latérale ferme l'ouverture (26).

8. Dispositif (1) de fabrication d'une cellule solaire à couche mince suivant l'une quelconque des revendications 1 à 6,
dans lequel la cathode (75) et l'anode (67) sont montées de manière à être sensiblement perpendiculaires à la partie (63) de plaque latérale en vue en plan,
la partie (27) de paroi de la chambre (11) de formation de film est pourvue d'une ouverture (26) qui est fermée par la partie (63) de plaque latérale, et
la cathode (75) et l'anode (67) sont démontées à l'extérieur de la chambre (11) de formation de film par l'ouverture (26) en retirant la partie (63) de plaque latérale fermant l'ouverture (26).

9. Dispositif (1) de fabrication d'une cellule solaire à couche mince suivant l'une quelconque des revendications 1 à 8,
dans lequel l'unité (31) d'électrode comprend en outre une unité (71) d'entraînement qui permet à l'anode (67) de se rapprocher et de se séparer de la cathode (75).

10. Dispositif (1) de fabrication d'une cellule solaire à couche mince suivant l'une quelconque des revendications 1 à 9,
dans lequel la cathode (75) est une plaque d'aspersion qui fournit du gaz filmogène à une surface du substrat (W) où un film doit être formé, et la partie (63) de plaque latérale a une partie d'introduction dans laquelle le gaz filmogène est introduit.

11. Dispositif (1) de fabrication d'une cellule solaire à couche mince suivant l'une quelconque des revendications 1 à 10,
dans lequel l'unité (31) d'électrode comprend en outre une unité (78) formant masque, qui délimite une plage de formation de film à la partie de bord extérieur du substrat (W).

12. Dispositif (1) de fabrication d'une cellule solaire à couche mince suivant l'une quelconque des revendications 1 à 11,
dans lequel l'unité (31) d'électrode comprend en outre un chariot (62A).

13. Dispositif (1) de fabrication d'une cellule solaire à couche mince suivant la revendication 12,
dans lequel le chariot (62A) peut être connecté et séparé de la partie (63) de plaque latérale.
